Europäisches Patentamt

European Patent Office

Office européen des brevets

(11) Publication number: **0 359 264 B1**

# EUROPEAN PATENT SPECIFICATION

(45) Date of publication of patent specification: **04.05.94**

(51) Int. Cl.5: **C23C 16/50**, C23C 16/44, C23C 16/22

(21) Application number: **89117041.7**

(22) Date of filing: **14.09.89**

(54) **Hydrogenated amorphous materials and thin films thereof.**

(30) Priority: **14.09.88 JP 228806/88**
**16.02.89 JP 34987/89**
**27.02.89 JP 43269/89**

(43) Date of publication of application:
**21.03.90 Bulletin 90/12**

(45) Publication of the grant of the patent:
**04.05.94 Bulletin 94/18**

(84) Designated Contracting States:
**DE FR GB**

(56) References cited:
**EP-A- 0 229 707          EP-A- 0 230 788**
**EP-A- 0 241 317          DE-A- 3 525 211**
**US-A- 4 717 585          US-A- 4 772 486**

**PATENT ABSTRACTS OF JAPAN, vol. 8, no. 281 (E-286)[1718], 21st December 1984; & JP-A-59 148 326**

(73) Proprietor: **FUJITSU LIMITED**
**1015, Kamikodanaka**
**Nakahara-ku**
**Kawasaki-shi Kanagawa 211(JP)**

(72) Inventor: **Kodama, Jun c/o Fujitsu Limited Pat. Dep.**
**1015 Kamikodanaka**
**Nakahara-ku**
**Kawasaki-shi Kanagawa 211(JP)**
Inventor: **Araki, Shin c/o Fujitsu Limited Pat. Dep.**
**1015 Kamikodanaka**
**Nakahara-ku**
**Kawasaki-shi Kanagawa 211(JP)**

(74) Representative: **Sunderland, James Harry et al**
**HASELTINE LAKE & CO**
**Hazlitt House**
**28 Southampton Buildings**
**Chancery Lane**
**London WC2A 1AT (GB)**

PROCEEDINGS OF THE EIGHT E.C. PHOTOVOLTAIC SOLAR ENERGY CONFERENCE, Florence,9th - 13th May 1988, vol. 2, pages 1211-1219, Kluwer Academic Publishers, Dordrecht, NL; Y. HAMAKAWA: "Electron cyclotron resonance CVD of a-SiC alloyand its application to opto-electronic devices"

THIN SOLID FILMS, vol. 101, no. 1, March 1983, pages 83-96, Elsevier Sequoia, Lausanne, CH; J.P. GERAULT et al.: "X-ray photoelectron spectroscopy and ramanspectroscopy investigations of amorphous SixC1-x(H) coatings obtained bychemical vapour deposition from thermally labile organosilicon compounds"

## Description

The present invention relates to hydrogenated amorphous materials, thin films thereof, and method and use of apparatus for forming thin films of hydrogenated amorphous materials, for example, hydrogenated amorphous silicon, hydrogenated amorphous carbon, hydrogenated amorphous silicon carbide.

Thin film hydrogenated amorphous materials, particularly hydrogenated amorphous silicons (hereinafter referred to as a-Si:H), are widely used in electrophotographic photosensitive members for electrophotographic apparatus, for forming images by irradiation with information-bearing light beams, since such materials exhibit excellent durability and do not become sources of environmental pollution.

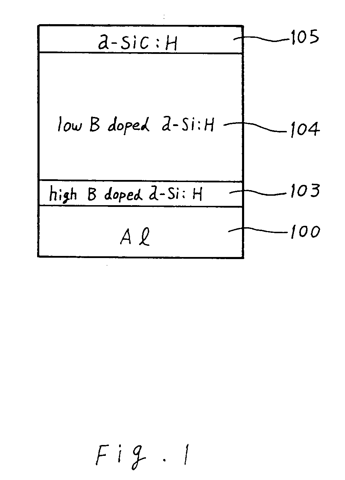

As shown in Fig. 1, a photosensitive layer 104 having a blocking layer for carrier injection 103, a carrier generation layer and a carrier transport layer 104 and a surface protecting layer 105 are layered sequentially on a conductive substrate 100 for example of aluminium (Al).

For this blocking layer of carrier injection, a P-type or an N-type a-Si:H, a-SiO:H, a-SiC:H, a-SiN:H is used, and for the photosensitive layer an a-Si:H is used. For the surface protecting layer, a-SiC:H, a-SiN:H, a-SiC:H, a-SiC:H:F are used. Particularly, for the surface protecting layer, an a-SiC:H or a-SiN:H having a wide band gap is used, but a-SiC:H is superior from the point of view of hardness.

However, when the surface layer includes Si, the Si reacts with oxygen in the air to form SiO, which is hydrophilic, and blurring may easily be generated under conditions of high humidity.

Therefore, methods involving use of a heated photosensitive material, or use of a film not including Si as the surface layer, have been employed.

However, when a heated photosensitive member is used, it is necessary to build a heating source into the electrophotographic apparatus, with the resulting problem that the configuration of the electrophotographic apparatus becomes complicated and expensive.

Meanwhile, when the surface layer does not include Si, there arises a problem that in light transmissivity, hardness and fitness with the photosensitive member are insufficient.

Beyond the context of such photosensitive members there is a need for thin insulation films for a variety of purposes.

According to the present invention there is provided a hydrogenated amorphous silicon carbide expressed by the general formula a-Si$_{1-x}$C$_x$:H and having a constitution such that a ratio (TO/TA) of the peak (TO) amplitude appearing in the vicinity of 480 cm$^{-1}$ and the peak (TA) amplitude appearing in the vicinity of 150 cm$^{-1}$ observed by laser Raman spectroscopy measurement using an excitation laser of Ar$^+$ 488 nm is 2.0 or higher, and such that the content of carbon (x) is in the range of $0.4 \leq x \leq 0.8$.

An embodiment of the present invention can provide an a-SiC:H for a photosensitive member which assures high light transmissivity, hardness and fitness (compatibility or matching) with the photosensitive member and which is not susceptible to generation of blurring under conditions of high humidity, even without use of a heating source.

An embodiment of the invention can provide an a-SiC:H which affords highly insulative properties. Thin films of such a-SiC:H can be employed as insulation films in thin film transistors, or in solar cells (batteries).

The inventors have found, as a result particularly of investigations of behaviour of the surfaces of a-Si:H photosensitive members through corona irradiation under high humidity conditions, by measurement of contact angle and high sensitivity reflection FT-IR (IR-RAS) measurements, that corona irradiation to a surface protecting layer of an a-Si:H photosensitive member under conditions of high humidity causes increase of Si-OH, H-OH, Si-O-Si, $NO_3^-$, $CO_3^{--}$ peaks at the surface thereof, thereby enhancing wettability. Namely, ozone ($O_3$) generated by the corona irradiation directly oxidizes the surface of the photosensitive member and increases Si-O-Si coupling. Simultaneously, it generates absorption groups such as $NO_3^-$, $CO^{3--}$ and OH and such absorption groups adhere to Si at the surface as a hydrate. As a result, polarity at the surface increases and wettability also increases. The polar molecule, $H_2O$ adheres thereto. When the surface is charged under such conditions, charges are able to flow and therefore (image) blurring occurs.

The inventors have had the insight that improvement so far as wettability is concerned may be afforded by increasing the content (X) of carbon in an a-Si$_{1-x}$C$_x$:H film used as a surface protecting layer (it being impossible or impractical to employ a material not including Si at the surface, in view of film characteristics as explained above) thereby facilitating provision of an a-Si photosensitive member which is resistive to humidity.

However, the inventors have also determined that an a-Si$_{1-x}$C$_x$:H having only a high content (X) of carbon is not sufficiently functional so far as blocking carrier injection is concerned, as a surface protecting layer. An embodiment of the present invention provides an a-Si$_{1-x}$C$_x$:H with a high content of carbon (x > 0.4) and which also has a value of 2.0 or more as the ratio of peak (TO) amplitude appearing in the vicinity of 480 cm$^{-1}$ observed by laser Raman spectroscopy measurement using an excitation laser of Ar$^+$ 488 nm

3

to the peak (TA) amplitude appearing in the vicinity of 150 cm$^{-1}$, for achieving an a-Si$_{1-x}$C$_x$:H film which ensures high content (X) of carbon and sufficient blocking function, as a surface protecting layer.

Embodiments of the invention also provide such a-Si$_{1-x}$C$_x$:H as an insulating thin film, of a thin film transistor or of a solar cell or battery for instance.

This a-Si$_{1-x}$C$_x$:H film according to an embodiment of the present invention has a special quality of high insulation.

Incidentally, an a-Si$_{1-x}$C$_x$:H film having high content (X $\geq$ 0.5) of carbon formed by well-known RF-CVD (radio frequency chemical vapour deposition) apparatus (for example, United States Patent No. 4 507 375, etc., on page 452 of "Electrophotographic Bases and Application", issued in 1988 by Corona Publishing Corporation) does not exhibit a blocking layer function and does not allow appearance of charging voltage because the density of film is deteriorated.

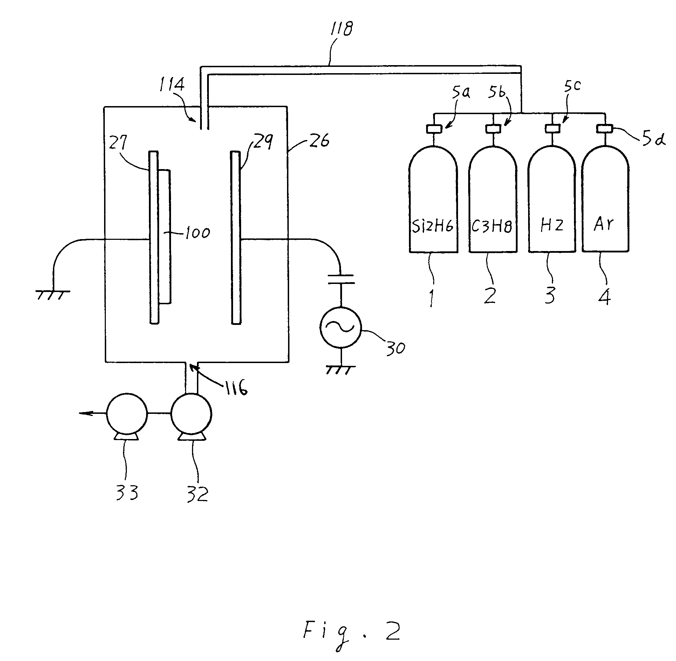

Fig. 2 is a schematic diagram of the constitution of previously proposed RF-CVD apparatus.

In Fig. 2, a substrate 100 on which an a-SiC:H film is to be formed is mounted on a second electrode 27 connected to ground, in a reactor vessel 26. This reactor vessel 26 is evacuated by a mechanical booster pump 32 connected to an outlet port 116 and a rotary pump 33. Meanwhile, the reactor vessel 26 has a pipe 118 at an inlet port 114. This pipe 118 is then connected with: a gas cylinder 1 containing disilane Si$_2$H$_6$, through a flow regulator 5a; a gas cylinder 2 containing propane C$_3$H$_8$, through a flow regulator 5b; a gas cylinder 3 containing hydrogen H$_2$, through a flow regulator 5c; and a gas cylinder 4 containing argon Ar, through a flow regulator 5d.

The gases contained in gas cylinders 1 to 4 are introduced to the reactor vessel 26, through the pipe 118, as starting gases only in quantities which depend on the adjustment afforded by respective flow regulators 5a to 5d.

In this condition, when radio frequency power is supplied to a first electrode 29 from a radio frequency power source 31, a plasma of starting gases is formed across the first and second electrodes 27, 29 and thereby an a-SiC:H film is formed on the substrate 100.

The RF-CVD apparatus as described above forms an a-Si$_{1-x}$C$_x$:H film having high content (X) of carbon when the flow rate of propane C$_3$H$_8$ contained in the gas cylinder 2 is increased, but forms only an a-Si$_{1-x}$C$_x$:H film which does not afford a blocking layer function.

EP-A-0 230 788 is concerned with the preparation of multi-layer structure film, such as an a:SiGe:H(F) and a:Si:H(F) multi-layer film, or an a:SiC and a:Si multilayer film, by RF-CVD. Silicon halide gas and active species of hydrogen are introduced into a reaction chamber. To provide the active species of hydrogen, microwave power is applied to molecular hydrogen gas passing through a reaction pipe to generate hydrogen atom radicals, which are then introduced to the reaction chamber from the reaction pipe. In the reaction chamber RF power is supplied to provide a glow discharge. The introduction of hydrogen atom radicals, rather than molecular hydrogen, to the chamber, is said to provide for control of amount of active species, so that film formation can be done at any mixing ratio of active species in the plasma in the reaction chamber.

According to the present invention there is provided the use of thin film formation apparatus for forming a dense, thin protective film of hydrogenated amorphous material on a substrate, said material containing an ingredient to reduce surface wettability, said apparatus comprising a reactor vessel, a first introducing means, a plasma generating means, a second introducing means, and a hydrogen radical generating means,

in which use
the substrate is placed in the reactor vessel, the first introducing means introduce starting gas into said reactor vessel, the plasma generating means generate plasma in said reactor vessel, the second introducing means deliver hydrogen gas, and the hydrogen radical generating means generate hydrogen radicals by decomposing hydrogen gas supplied by said second introducing means, and the generated hydrogen radicals are sent to said substrate in the reactor vessel.

According to the present invention there is provided a method of forming a dense, thin protective film of hydrogenated amorphous material on a substrate, said material containing an ingredient to reduce surface wettability, said method comprising steps of:-

(a) forming said film by generating a plasma of a starting gas suitable for forming said material within a deposition space where a substrate is positioned,

(b) generating hydrogen radicals by decomposing a hydrogen gas, and

(c) introducing a sufficient amount of hydrogen radicals into said deposition space in the proximity of the substrate to cover the surface of the amorphous material film as it forms.

Embodiments of the present invention can provide a method and a mode of use of apparatus for forming an a-Si$_{1-x}$C$_x$:H film having the characteristics described above. That is, a sufficient blocking

4

function can be afforded, or suitable insulation properties provided, by the film.

The methods and mode of use of apparatus involved in such embodiments of the invention can of course be used or adapted for forming films of hydrogenated amorphous substances other than the amorphous silicon carbide mentioned above.

In such embodiments a long-life hydrogen radical ($\cdot$H) generated by decomposition of hydrogen gas ($H_2$) e.g. with microwaves of suitable frequency (e.g. 2.45 GHz), or arc discharge, etc., is sent to the reactor vessel, the deposition space, for plasma decomposition of the starting gases.

In the view of the inventors, density of the film produced can be thought of as being improved by covering the reaction surface effectively with the hydrogen radical ($\cdot$H).

Atomic coupling energy is as follows:-

| H-H > 4.88eV | C-H > 4.29eV | C-C > 3.58eV | Si-C > 3.38eV | Si-Si > 3. 10eV | Si-H 3.06eV. |
|---|---|---|---|---|---|

Formation of a dense film during formation of $a\text{-}Si_{1-x}C_x$:H film is thought to reduce dangling bond (DB) of Si atom. This means that an increased carbon ratio x causes hydrogen to be coupled with carbon in large quantities as a result of coupling energies as described above. As a result, in the view of the inventors, it can also be thought that DB of Si atom increases and the film is thereby deteriorated. In order to prevent this phenomenon, such DB is decreased by covering the reaction surface with excessive hydrogen ($\cdot$H) and Si-C coupling is increased by generating recoupling of H-H at the surface. Thereby, the film can be made more dense. Mr. Matsuda et al. propose that a film can be increased in density by reducing hydrogen ($H_2$), but the inventors have found that the blocking characteristic of such a a-SiC:H film is bad when content of carbon is high. Therefore, when hydrogen ($H_2$) has been replaced with hydrogen radical ($\cdot$H), it can cover the surface because it is more active than hydrogen ($H_2$) and the film can be densed (densified) even with a higher content of carbon.

Reference is made, by way of example, to the accompanying drawings, in which:-

Fig. 1 is a schematic diagram of a constitution of an a-Si photosensitive member,

Fig. 2 is a diagram illustrating constitution of a prior art RF-CVD apparatus,

Fig. 3 is a structural diagram of a thin film formation apparatus used in accordance with an embodiment of the present invention,

Fig. 4 is a perspective view of a thin film formation apparatus used in accordance with an embodiment of the present invention,

Fig. 5 gives diagrams explanatory of a method of introducing propane gas as employed in accordance with an embodiment of the present invention,

Fig. 6 is a perspective view of thin film formation apparatus used in accordance with an embodiment of the present invention, for generating a photosensitive member drum;

Fig. 7 is a graph showing results of IR-RAS measurement;

Fig. 8 is a diagram explanatory of laser Raman spectroscopy measuring apparatus,

Fig. 9 is a graph showing results of laser Raman spectroscopy measurement,

Fig. 10 is a graph showing a relationship between a content of carbon and a TO/TA ratio,

Fig. 11 is an explanatory perspective diagram, for assistance in explanation of a further embodiment of the present invention,

Fig. 12 is a diagram illustrating constitution of a hydrogen radical inlet port,

Fig. 13 is an explanatory schematic plan diagram of apparatus used in accordance with another embodiment of the present invention,

Fig. 14 is a diagram explanatory of a hydrogen radical inlet port,

Fig. 15 is a graph indicating light emission intensity H for a distance D between a plasma generating furnace and a substrate,

Fig. 16 is a schematic diagram explanatory of apparatus used in accordance with a further embodiment of the present invention,

Fig. 17 is a diagram explanatory of a hydrogen radical generator,

Fig. 18 is a graph showing results of laser Raman spectroscopy measurement,

Fig. 19 is a schematic plan diagram explanatory of apparatus used in accordance with a further embodiment of the present invention,

Fig. 20 is a schematic diagram explanatory of apparatus used in accordance with another embodiment of the present invention.

5

Fig. 21 is a schematic diagram explanatory of apparatus used in accordance with another embodiment of the present invention,

Fig. 22 is a schematic diagram explanatory of apparatus used in accordance with a further embodiment of the present invention,

Fig. 23 is a schematic diagram explanatory of apparatus used in accordance with another embodiment of the present invention,

Fig. 24 is a schematic diagram explanatory of hydrogen radical generating apparatus.

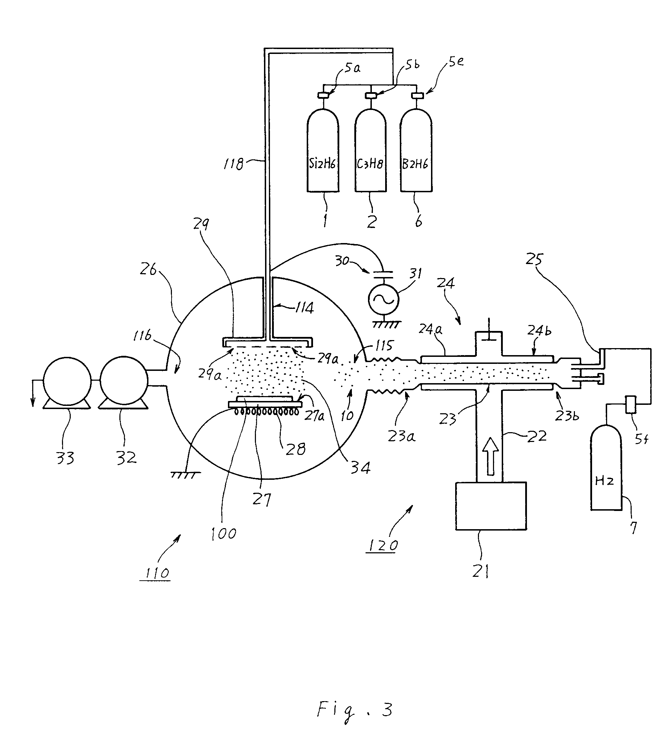

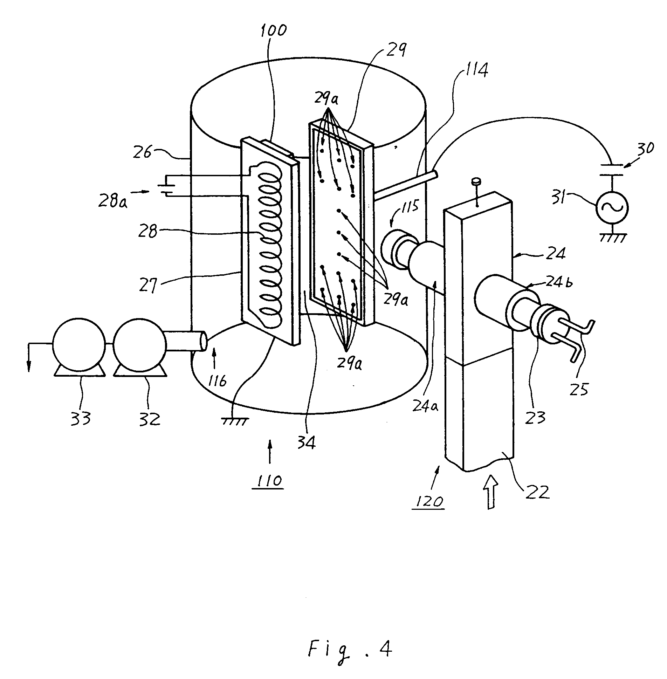

Referring to Figs. 3 and 4, thin film formation apparatus, generally designated by reference numeral 110, has a reactor vessel 26 having a first inlet port 114, second inlet port 115 and an outlet port 116. The inlet port 114 is connected to one end of an inlet pipe 118, the other end of which is connected to a suitable starting gas source 1, 2, 6, the outlet port 116 is connected to a suitable vacuum pump comprising a rotary pump 33 and a mechanical booster pump 32.

The inlet pipe 118 is connected with: a gas source 1 containing disilane ($Si_2H_6$), through a flow regulator 5a; a gas source 2 containing propane ($C_3H_8$), through a flow regulator 5b; and a gas source 6 containing diborane ($B_2H_6$), through a flow regulator 5e. Diborane ($B_2H_6$) is reduced by helium He and is contained in the gas source so that it has concentration of 100 ppm for He.

The second inlet port 115 connects to a hydrogen radical generating means 120. This hydrogen radical generating means 120, the one end thereof (23a) being connected to the second inlet port 115 and the other end (23b) to a gas source 7 described below, has a quartz pipe 23 of 30 mm diameter through which hydrogen ($H_2$) is applied, and to a hydrogen gas inlet port 25 at the other end 23b of the quartz pipe 23 (away from the inlet port 115) through a flow regulator 5f, and comprises a gas source 7 containing hydrogen gas, a microwave oscillator 21 for generating microwaves of 2.45 GHz, a waveguide 22 for guiding microwaves to the quartz pipe 23 and a plasma generating furnace 24 which has cylindrical portions 24a and 24b covering the quartz pipe 23 for generating plasma of hydrogen gas passing through the quartz pipe 23, the entire circumference and total area in the longitudinal direction of the quartz pipe 23 being irradiated with microwaves guided by the waveguide 22.

The thin film formation apparatus 110 also comprises first and second electrodes 29 and 27, arranged in opposition within the reactor vessel 26 to define a discharge zone therebetween; the first and second electrodes 29 and 27 being formed of a suitable conductive material such as a stainless steel.

The first electrode 29 has opening holes 29a for supplying the starting gas supplied through the inlet port 114 to the reactor vessel 26. These opening holes 29a are provided in large number in upper and lower sections of the first electrode, and in small number in the centre area of the electrode, as shown in Fig. 4, so that the starting gas supplied from the inlet port 114 is uniformly released in the longitudinal direction of a substrate 100.

The first electrode 29 is connected to a radio frequency electric source 31 through an impedance matching box (not shown) and a blocking capacitor 30; the RF source 31 (13.56 MHz) being grounded as shown in Fig. 3.

Further, the second electrode 27 includes a rectangular flat portion 27a and is mounted on the bottom inner wall of the reactor vessel 26, and is grounded as shown in Fig. 3. A substrate 100 is put on the flat portion 27a at a predetermined location, and is heated by a suitable electric heater 28 incorporated therein. This heater 28 is driven by a power source 28a.

The photosensitive member of the constitution shown in Fig. 1 may be formed by the following method, using the thin film formation apparatus shown in Fig. 3 and Fig. 4:-

(1) First, a substrate 100 of aluminium Al, etc., is set under atmospheric conditions on second electrode 27 which is located in opposition to first electrode 29 to form a deposition space 34 therewith, within the reactor vessel 26.

(2) Next, air is drawn from the reactor vessel 26 through the outlet port 116 by the vacuum pumps 32, 33 until pressure in the reactor vessel 26 is lower than 0.2 Torr (0.026 KPa). Then the substrate 100 is heated to a predetermined temperature (250°C) by the electric heater 28 while a starting gas is successively introduced into the reactor vessel 26 through the inlet port 114 and the opening holes 29a so that the pressure therein is maintained at a predetermined level (0.2 Torr -0.026 KPa). The vacuum pumps 32, 33 are continuously driven.

(3) Thereafter, only the flow regulators 5a, 5e are released and thereby only disilane $Si_2H_6$ from the gas source 1 and diborane $B_2H_6$ from the gas source 6 are introduced to the reactor vessel 26 through the flow regulators 5a, 5e, pipe 118, inlet port 114 and opening holes 29a of first electrode 29. In this case, the flow rate of disilane $Si_2H_6$ is 30 SCCM (standard cubic centimetre per minute: mass flow rate at 0°C, 1 atm -[1 atm = 0.101325 MPa]) and the flow rate of diborane $B_2H_6$ is 42 SCCM.

(4) Under these conditions, radio frequency (RF) power of 100 W is applied to the first electrode 29 from the radio frequency source 31. As a result, the starting gas consisting of disilane $Si_2H_6$ and diborane $B_2H_6$ is decomposed in the deposition space 34 and becomes a plasma. Thereby, an a-Si:H film to which boron (B) is doped in higher degree is formed on the substrate 100 until a thickness of 0.56 $\mu$m is reached. This a-Si:H film is a blocking layer 103.

(5) After formation of the blocking layer 103 on the substrate 100, the pressure in the reactor vessel 26 is reduced to about 0.1 Torr (0.013 KPa) and maintained at this level. Simultaneously with such pressure reduction operation, the flow regulator 5e is adjusted so that the flow rate of diborane $B_2H_6$ becomes 1 SCCM. RF power is 100 W.

(6) An a-Si:H film to which boron (B) is doped in a lower degree is formed on the blocking layer 103 until a thickness of 3 to 4 $\mu$m is reached. This a-Si:H film is the photosensitive member layer 104.

(7) After formation of the photosensitive member layer 104, the film forming conditions of the thin film formation apparatus are changed as indicated below and a surface protecting layer 105 is formed to a thickness of 0.18 $\mu$m on the photosensitive member layer 104.

Pressure: 0.013 KPa (0.1 Torr)

Substrate temperature: 250°C

RF power: 100 W

Flow rate of $Si_2H_6$: 2 SCCM

Flow rate of $C_3H_8$: 20 SCCM

Flow rate of $H_2$: 100 SCCM

Microwave power: 380 W

Namely, the flow regulator 5e is closed after formation of the photosensitive member layer 104, with the pressure set to 0.1 Torr (0.013 KPa) and the substrate temperature is maintained at 250°C. Thereby, the flow rate of diborane ($B_2H_6$) is set to 0 SCCM.

Meanwhile, the flow rate of disilane $Si_2H_6$ from the gas source 1 can be set to 2 SCCM by the flow regulator 5a, and that of propane $C_3H_8$ from the gas source 2 to 20 SCCM by the flow regulator 5b, respectively. The disilane $Si_2H_6$ and propane $C_3H_8$ are introduced into the reactor vessel 26 as the starting gas through the inlet port 114. Simultaneously, hydrogen gas $H_2$ from the gas source 7 is also introduced into the reactor vessel 26 by the flow regulator 5f through the hydrogen gas introducing pipe 25 and the inlet port 115. The flow rate of $H_2$ is set to 100 SCCM.

(8) Under these conditions, radio frequency power of 100 W is applied to the first electrode 29 from the radio frequency electric source 31 and simultaneously or immediately after such application, microwave power of 380 W is supplied to the microwave oscillator 21.

When a predetermined RF voltage is applied between the first and second electrodes 29 and 27 by the RF electric source 31 to cause an RF discharge therebetween, electrons generated by the RF discharge collide with the starting gas molecules so that a plasma zone is formed between the first and second electrodes 29 and 27. At the beginning of the RF discharge, the electrons, which are vibrated in the vicinity of the first electrode 29, are captured by the first electrode 29 due to the existence of the blocking capacitor 30, so that a potential of the first electrode 29 is self-biased toward the negative side.

The hydrogen gas in the quartz pipe 23 introduced from the hydrogen gas introducing pipe 25 of quartz pipe 23 is sent to the waveguide 22 and becomes plasma and then hydrogen radical ($\cdot$H) 10 due to the microwaves applied in the plasma generating furnace 24.

This hydrogen radical ($\cdot$H) 10 is guided to the plasma zone 34 in the reactor vessel 26.

Thereby, a sufficient amount of hydrogen radical ($\cdot$H) 10 is supplied between the first electrode 29 and second electrode 27 and an a-$Si_{1-x}C_x$:H film containing a large amount of carbon (e.g. x = 0.8) is formed.

Therefore, this thin film formation apparatus in use forms sufficient coupling with silicon (Si) in the coupling energy lower than that for carbon (C). Accordingly, the a-SiC:H film thus formed has less dangling bond (DB) of Si atoms and is densed (densified).

An a-Si photosensitive member provided as described above has good electrical characteristics, such that charging voltage is 500 V, residual potential is 5 V, half-value exposure is 1.0 $\mu$J/cm$^2$.

Moreover, this a-Si:H photosensitive member does not exhibit blurring even under ambient conditions of 35°C and 85% RH (relative humidity) and exhibits excellent characteristics so far as moisture resistance is concerned.

The present invention will be understood more readily by reference to the following further examples. It should be noted that these examples are illustrative and exemplary only.

EXAMPLE 1

After formation of the blocking layer 103 and photosensitive member layer 104 on the substrate 100 by the method described above using the thin film formation apparatus shown in Fig. 3 and Fig. 4, samples each with a surface protecting layer 105 were formed by setting film forming conditions as indicated in Table 1.

Table 2 indicates the electrical characteristics of the sample a-Si photosensitive members formed under the film forming conditions of Table 1.

The a-Si:H photosensitive member of sample No. C2-3 does not generate blurring under atmospheric conditions of 35°C and 80% RH. Sample No. C2-2 generates blurring. Sample No. C2-1 sometimes generates blurring.

For the purpose of comparison, an a-Si photosensitive member was manufactured under the same film forming conditions as for sample No. C2-3, using the previously proposed RF-CVD apparatus as shown in Fig. 2.

This a-Si photosensitive member provided a charging capability of only 20 (V/$\mu$m) at maximum.

Table 1

| No | Gas Flow Rate (SCCM) | | | Flow rate ratio r |
|----|------|------|------|------|
| | $Si_2H_6$ | $C_3H_8$ | $H_2$ | |
| C2-2 | 5 | 5 | 100 | 0.50 |
| C2-1 | 2.2 | 10 | 100 | 0.82 |
| C2-3 | 2.2 | 20 | 100 | 0.90 |

Common conditions:

Pressure: 0.2 Torr (0.026 KPa)
RF power: 100W
Microwave power: 380W
Substrate temperature: 250°C
r = $C_3H_8/(C_3H_8 + Si_2H_6)$

Table 2

| Sample No | Charging voltage (corotron voltage (KV)) (V) | Charging capability (V/um) | Residual voltage (V) | Dark attenuation time (S) | Content of carbon (x) |
|-----------|------|------|------|------|------|
| C2-2 | 125 (+8.0) | 32.3 | 3 | 27 | 0.3 |
| C2-1 | 130 (+9.5) | 32.7 | 8 | 30 | 0.45 |
| C2-3 | 190 (+9.0) | 44.9 | 9 | 65 | 0.7 |

EXAMPLE 2

Table 3 compares physical characteristics of a-SiC:H films directly formed on flat substrates 100 by the film formation apparatus (HR-CVD Hydrogen Radical - Chemical Vapor Deposition) shown in Fig. 3 and Fig. 4 and by the previously proposed RF-CVD apparatus shown in Fig. 2.

Table 3

| Film forming system (Sampel No.) | HR-CVD (CI-8M) | RF-CVD (CI-9HI) |
|---|---|---|
| $E_{gopt}$ (eV) | 2.52 | 2.53 |
| B value ($cm^{-1/2}eV^{-1/2}$) | 600 | 400 |
| Contact angle (deg) | 84 | 70 |

Film forming conditions:-

Pressure: 0.2 Torr (0.026 KPa)
Substrate temperature: 250 °C
RF power: 100 W
Flow rate of $Si_2H_6$: 2.2 SCCM
Flow rate of $C_3H_8$: 20 SCCM
Flow rate of $H_2$: 100 SCCM
Microwave power: 380 W (HR-CVD only).
r: 0.9.

The contents of carbon in these samples can be considered to be almost equal (from the value of $E_{gopt}$).The B value of the film manufactured by the HR-CVD apparatus is larger than that of the film manufactured by the other apparatus and the contact angle thereof is also increased because density of film may be increased by introducing hydrogen radical into the deposition space.

EXAMPLE 3

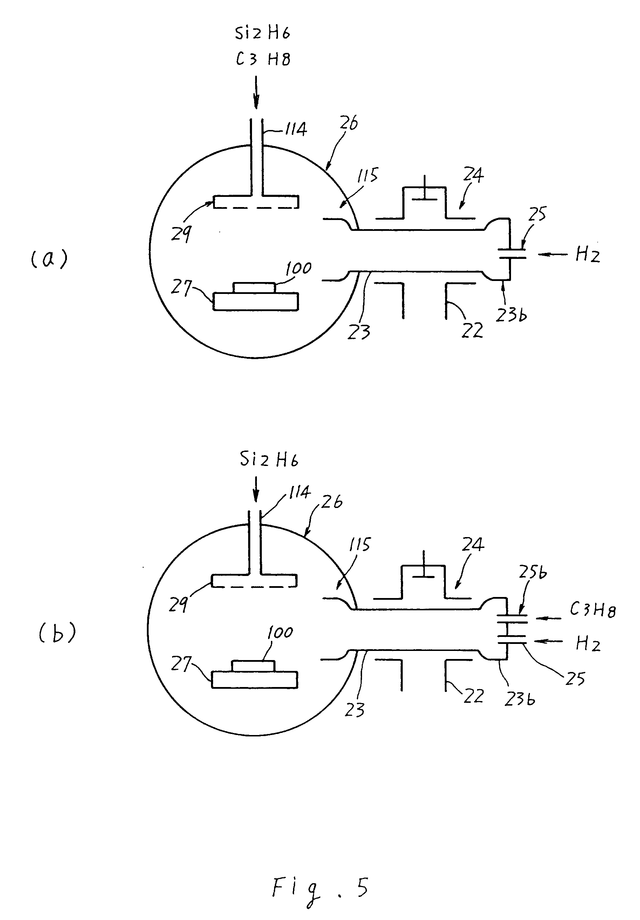

Table 4 shows a comparison between a sample No. CI-3, manufactured by (a) introducing propane $C_3H_8$ together with disilane $Si_2H_6$ to the reactor vessel 26 through the pipe 118 using the thin film formation apparatus shown in Fig. 3 and Fig. 4, and a sample No. CI-4, manufactured by (b) introducing propane $C_3H_8$ together with hydrogen $H_2$ from the end part 23b of the quartz pipe 23 to the reactor vessel 26. Fig. 5 is an explanatory diagram of the method of introducing propane $C_3H_8$. Fig. 5(a) shows conditions when supplying disilane $Si_2H_6$ and propane $C_3H_8$ through the pipe 118 and inlet port 114, whilst Fig. 5(b) shows conditions when supplying propane $C_3H_8$ to a propane introducing pipe 25b to the end part 23b of the quartz pipe 23.

Table 4

| Introducing system (Sample No.) | a (CI-3) | b (CI-4) |
|---|---|---|
| $E_{gopt}$(eV) | 2.12 | 2.12 |
| B value ($cm^{-1/2} eV^{-1/2}$) | 715 | 699 |
| Contact angle (deg) | 73 | 59 |

The comparison suggests that system (a) provides better results. With system (b), $C_3H_8$ is decomposed to provide carbon atoms (C) within the quartz pipe 23 and thereby $CH_n$, $C_2H_n$ radicals increase. In this case, the density of film is probably lost because hydrogen of Si-H at the outermost surface of the a-SiC:H film formed on the substrate 100 in the deposition space 34 is drawn and thereby the dangling bond of Si atoms increases.

Film forming conditions:-

Pressure: 0.2 Torr (0.026 KPa)
Substrate temperature: 250 °C
RF power: 100 W
Flow rate of $Si_2H_6$: 3 SCCM
Flow rate of $C_3H_8$: 7 SCCM

9

Flow rate of $H_2$: 100 SCCM
Microwave power: 360 W
r: 0.7.

## EXAMPLE 4

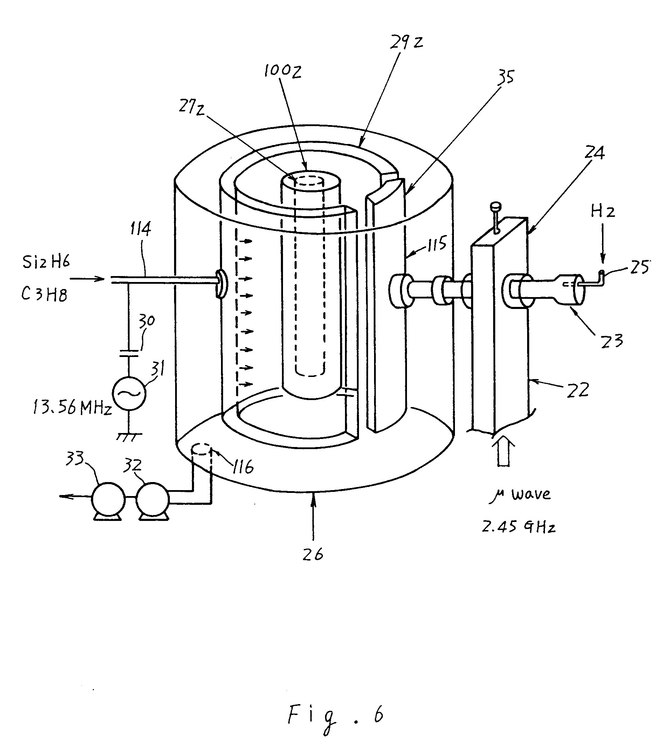

Fig. 6 shows thin film formation apparatus in accordance with an embodiment of the present invention, for manufacturing a photosensitive member drum. The second electrode 27 of the thin film formation apparatus (HR-CVD) shown in Fig. 3 and Fig. 4 is cylindrically formed (27z) and it is rotatably driven by a drive motor (not shown), to carry a cylindrical substrate 100z. The first electrode 29 is formed as an arcuated electrode (29z) surrounding almost the entire circumference of the second electrode 27z, and a hydrogen radical introducing part 35 is provided to uniformly introduce the hydrogen radical supplied from the inlet port 115 in the longitudinal direction of the substrate 100. This hydrogen radical introducing part 35 is formed to the same shape as the first electrode 29 shown in Fig. 4.

The a-SiC:H film was formed by setting the following film forming conditions in the thin film formation apparatus thus provided. Thus, a-SiC:H films are formed, as in EXAMPLE 1, on the cylindrical substrate 100z, to provide a blocking layer 103 and photosensitive member layer 104 by the same method and under conditions as described previously.

Film forming conditions:-

Pressure: 0.2 Torr (0.026 KPa)
Substrate temperature: 250°C
RF power: 100 W
Flow rate of $Si_2H_6$: 2.2 SCCM
Flow rate of $C_3H_8$: 10 SCCM
Flow rate of $H_2$: 200 SCCM
Microwave power: 540 W
r: 0.8.

Table 5 shows the characteristics of the a-Si photosensitive member formed as explained previously.

Table 5

| | |
|---|---|
| Charging voltage (V) | 360(for the current of 120 uA flowing into the drum) |
| Residual voltage (V) | 5 |
| Charging capability (V/um) | 36.7 |
| Contact angle (deg) | 80 85 |
| Moisture proof characteristic | No blurring under the atmospheric condition of 35°C and 80%RH |
| Content of carbon (x) | 0.45 |

This a-Si photosensitive member drum exhibits good water repellent characteristics and the contact angle is in the range of 80° to 85°, although it varies a little depending on position. This a-Si photosensitive drum gave good printing results without "blurring" during an environmental test under atmospheric conditions of 35°C and 80% RH even after continuous Corona irradiation for two hours and leaving the drum overnight.

## EXAMPLE 5

An a-SiC:H film is formed directly on an A substrate (e.g. an aluminium substrate) under the same film forming conditions, for the purpose of investigating an a-SiC:H film (hereinafter referred to as a-SiC:H ① ) formed by the thin film formation apparatus (HR-CVD) shown in Fig. 3 and Fig. 4 and an a-SiC:H film (hereinafter referred to as a-SiC:H ② ) formed by the prior art RF-CVD apparatus.

Film forming conditions:-

Pressure: 2.0 Torr (0.026 KPa)
Substrate temperature: 250°C

RF power: 100 W

Flow rate of $Si_2H_6$: 2.0 SCCM

Flow rate of $C_3H_8$: 10 SCCM

Flow rate of $H_2$: 200 SCCM

Microwave power: 500 W (HR-CVD only).

Table 6 shows the characteristics of a-SiC:H film manufactured as described.

Table 6

|  | a-SiC:H ① | a-SiC:H ② |
|---|---|---|
| $E_{gopt}$ (eV) | 2.21 | 2.14 |
| B value ($cm^{-1/2}\ eV^{1/2}$) | 674 | 641 |
| Contact angle (deg) | 79 | 72 |
| Content of carbon (x) | 0.45 | 0.45 |

With a view to investigating the difference between these two kinds of a-SiC:H film, the films were irradiated with a corona for 60 minutes by a corona charger under atmospheric conditions of 35°C and 80% RH, for measurements of the surface conditions by a high sensitivity reflection method (IR-RAS) using a Fourier transformation infrared spectroscopic analyser (FT-IR) (JIR-3505 manufactured by JEC).

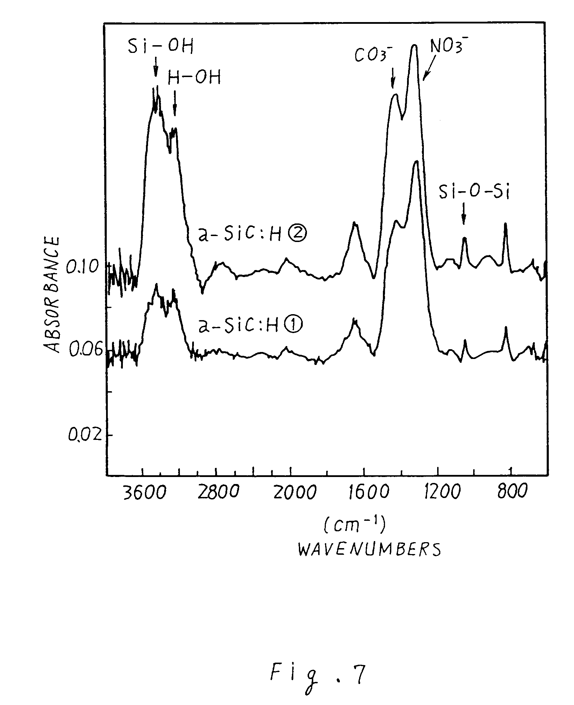

Fig. 7 is a graph showing measurement results of the IR-RAS. In comparison with a-SiC:H ②, the a-SiC:H ① film is about 1/3 in the absorption and oxidation regarding Si of the Si-O-Si, Si-OH, H-OH, etc.

Here, laser Raman spectroscopic measurement was conducted for investigating the difference between the constitutions of the two a-SiC:H films.

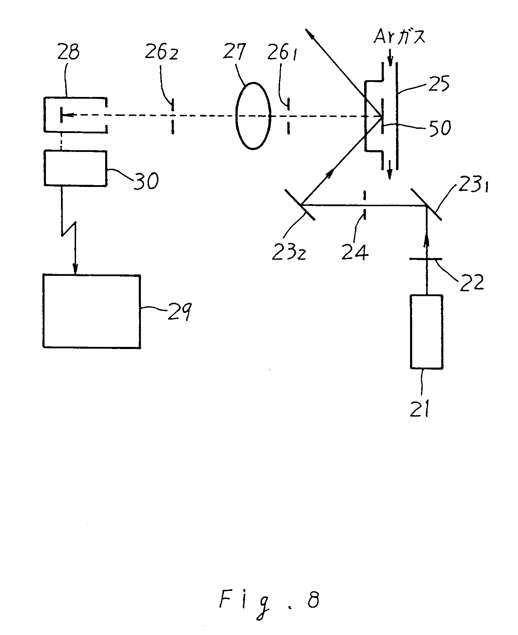

Fig. 8 is a diagram explanatory of laser Raman spectroscopy measurement for measuring density of constitution of an a-SiC:H film. The laser oscillated from the $Ar^+$ 488 nm oscillator 21 for excitation laser oscillation passes an interference filter 22 and enters with an incident angle of 45° a sample cell 25 to which the Ar gas is applied through a mirror $23_1$, a slit 24 and a mirror $23_2$. A sample 50 is a film deposited on the substrate 100. The Raman scattering beam emitted from the sample 50 is sent to a spectrometer 28 through a slit $26_1$, a condenser lens 27 and a slit $26_2$ and is converted to the spectrum in a data processing unit 29. 30 designates a photomultiplier.

For measurements in relation to a-SiC:H film, a laser Raman spectrometer manufactured by JEC was used.

The spectrum result obtained by this measurement shows that two kinds of peaks, TO (about 488 $cm^{-1}$) and TA (about 150 $cm^{-1}$), can be obtained for a-SiC:H film, a TO/TA peak ratio indicates disturbance of symmetricity of Si coupling or constitution thereof and larger value of such ratio suggests higher density of constitution.

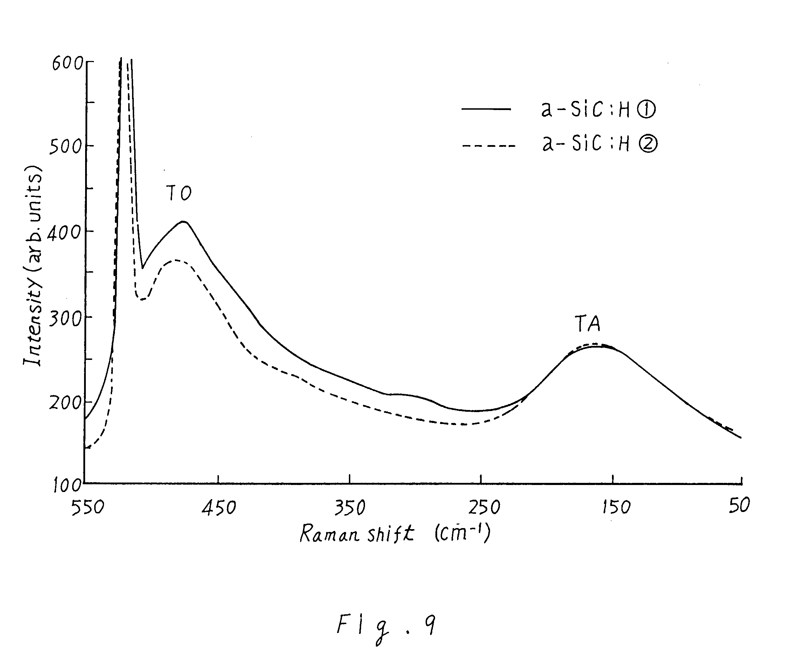

Fig. 9 shows the results of laser Raman spectroscopy measurements of a high density a-SiC:H ① film in comparison with a conventional a-SiC:H ② film. As a result, TO/TA of a-SiC:H ② is 1.8 and that of a SiC:H ① is 2.4, proving the constitution of the latter is more densed. This effect is thought to result from the reason explained hereunder.

When carbon is contained in a-Si:H, the Si network is disturbed to a certain degree. As a result, reactivity of Si at the surface of an a-SiC:H film increases, and the surface is oxidized by ozone ($O_3$) generated by the corona irradiation and can easily be changed to Si-O-Si and Si-OH. However, it is thought that reactivity of surface Si can be suppressed by forming a high density a-SiC:H film and moreover, surface absorption and oxidation by corona irradiation under high humidity conditions can be mitigated or eliminated, thus preventing blurring.

In order to investigate a relationship between content of carbon (x) of a-SiC:H film and TO/TA ratio, a-SiC:H films of different contents of carbon (x) were manufactured by changing the flow rates of disilane $Si_2H_6$, propane $C_3H_8$ and hydrogen $H_2$.

Table 7 shows relationships between flow rate, content of carbon (x) and contact angle.

### Table 7

Unit: SCCM

| No. | $Si_2H_6$ | $C_3H_8$ | $H_2$ | Content of carbon (x) | Contact angle (deg) a-SiC:H ① | a-SiC:H ② |
|---|---|---|---|---|---|---|
| 1 | 5 | 5 | 200 | 0.3 | 70 | 60 |
| 2 | 2.2 | 10 | 200 | 0.45 | 80 | 77 |
| 3 | 2.4 | 10 | 200 | 0.6 | 81 | 80 |
| 4 | 2.2 | 20 | 200 | 0.7 | 82 | 80 |

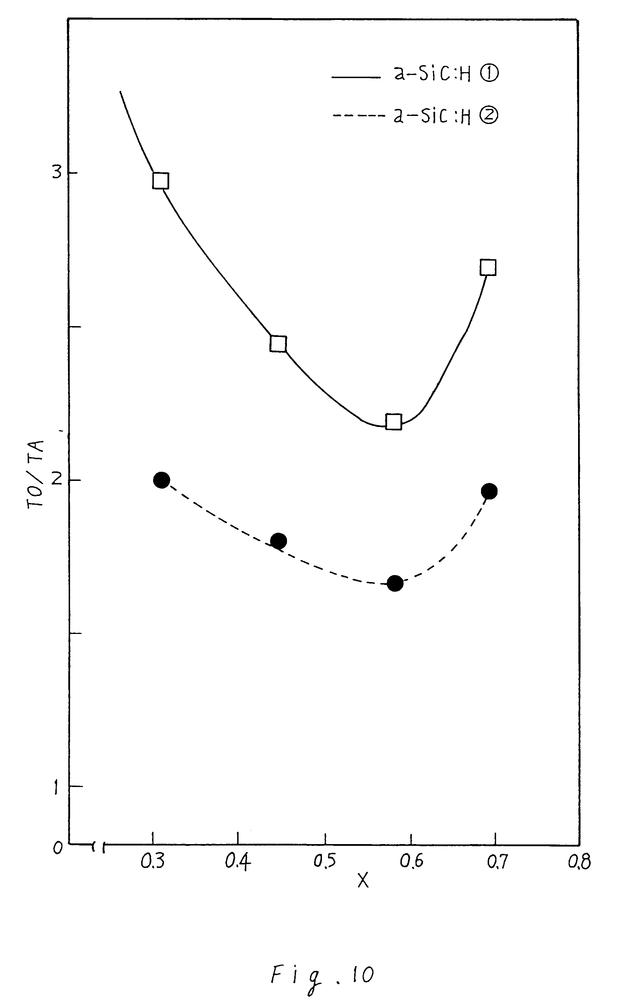

Fig. 10 is a graph showing relationships between content of carbon (x) and TO/TA ratio. As will be understood from Fig. 10, a-SiC:H ① film has a TO/TA ratio of 2.0 or higher and shows a higher density of film than a-SiC:H ②.

As a result of image formation in an atmosphere at 35°C and 80% RH using a-Si photosensitive members with a-SiC:H ① films formed as the surface protecting layers, a a-Si photosensitive member having a surface protecting layer with carbon content of 0.3 generated blurring but the other a-Si photosensitive members did not show blurring.

When the carbon content x of $a\text{-}Si_{1-x}C_x$:H film is set to $x \geq 0.8$, a carbon-rich constitution is obtained, reducing insulation characteristics and charging capability.

Therefore, the optimum hydrogenated amorphous silicon carbide expressed by the general formula $a\text{-}Si_{1-x}C_x$:H should have a ratio (TO/TA) of the peak (TO) amplitude appearing in the vicinity of 480 cm$^{-1}$ and the peak (TA) amplitude appearing in the vicinity of 150 cm$^{-1}$, observed by the laser Raman spectroscopy measurement using an excitation laser of Ar* 488 nm, of 2.0 or more, and a carbon content (x) in the range of $0.4 \leq x \leq 0.8$.

Respective values in EXAMPLES 1 to 5 were measured by the measuring methods described below.

1) Contact angle:-

The 20 $\mu l$ of pure water was dropped on to a sample placed horizontally by a microcylinder (type 4780, manufactured by Eppendorno and the drops were taken directly side on by a camera (RZ 67, manufactured by Mamiya), and the formula 2(h/d) = $\tan\theta$ was used for calculation from the width d and height h of the drops.

(2) Measurement of $E_{gopt}$:-

Absorption at a wavelength of 200 to 800 nm of an a-SiC:H film deposited on a substrate was measured using an ultraviolet visible spectrophotometer (UV-3400, manufactured by Hitachi). An optical band gap ($E_{gopt}$) and a B value were obtained using formula (1). The B value indicates a gradient of a tail part of a band, as a criterion of film density.

$$\alpha (\omega) = B (h\omega - E_{gopt})^2/h\omega \qquad (1)$$

Here,

$\alpha (\omega)$; absorption coefficient

$\omega$ ; number of vibrations (angular frequency)

h; Planck's constant.

(3) Charging voltage:-

This value was obtained using a paper analyser (Model SP-428, manufactured by Kawaguchi Electric).

(4) Residual potential:-

A sample charged by the apparatus mentioned at (3) immediately above was irradiated with a light beam of wavelength 675 nm and of quantity $0.476 \times 10^2$ mW/m$^2$ and the potential for minimum charging defined as a residual potential Vr.

(5) Dark attenuation time:-

The time taken for charging voltage to be reduced to a half, after a sample was charged, using apparatus mentioned at (3) above, was defined as the dark attenuation time $t_{1/2}$.

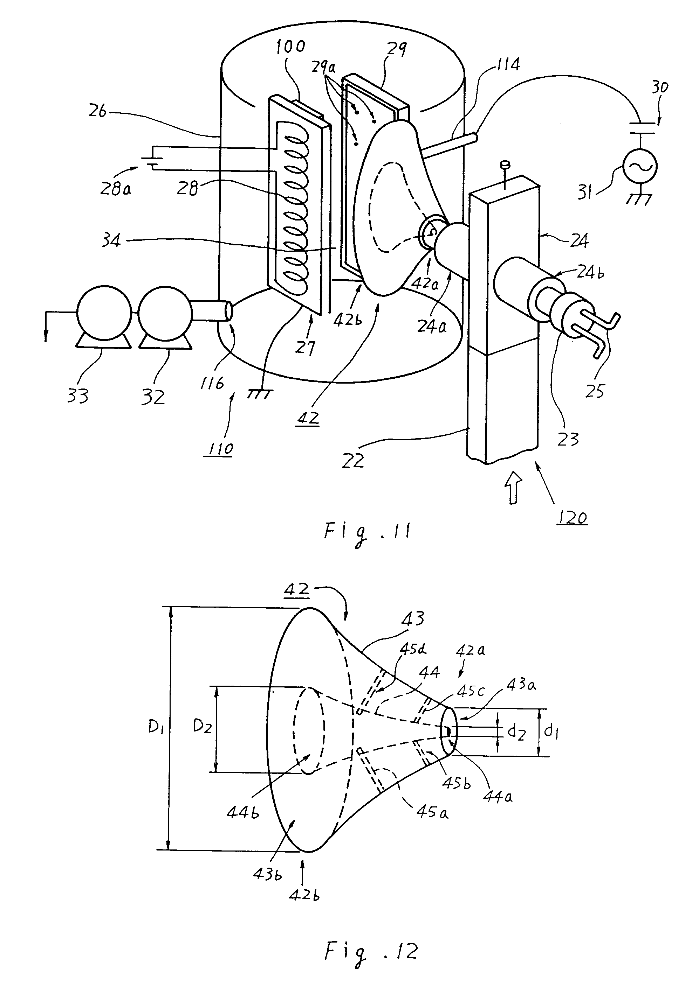

Fig. 11 is a diagram for explaining thin film formation apparatus used in accordance with another embodiment of the present invention. In the embodiment shown in Fig. 11, the thin film formation apparatus provides a hydrogen radical introducing unit 42, which uniformly introduces the hydrogen radical ($\cdot$H) generated by the hydrogen radical generating unit 120 along the longitudinal direction of substrate 100 placed on the second electrode 27 in the reactor vessel 26, between the reactor vessel 26 and hydrogen radical generating unit 120 of Fig. 3 and Fig. 4.

As shown in Fig. 12, this hydrogen radical introducing unit 42 has, concentrically or coaxially arranged, an outer wall 43 and an inner wall 44 of progressively increasing width (in the manner of flared cones). These walls are coupled with holding rods 45a, 45b, 45c, 45d ..... An end part 42a of the hydrogen radical introducing unit 42 is connected with an output port of hydrogen radical generating unit 120, namely with the end part of quartz pipe 23. The entire hydrogen radical introducing unit 42 is arranged within a vacuum vessel (e.g. reactor vessel 26) with an open end 42b of hydrogen radical introducing unit 42 provided in opposition to the deposition space 34.

The hydrogen radical generated in the plasma generating furnace 24 during film formation spreads uniformly in the deposition space 34 through the outer wall 43 and inner wall 44 of the hydrogen radical introducing unit 42. In this case, uniformity can be adjusted by varying an opening diameter $d_1$ of an end part 43a of outer wall 43, an opening diameter $d_2$ of an end part 44a of inner wall 44, an opening diameter $D_1$ of an end part 43b of outer wall 43 and an opening diameter $D_2$ of an end part 44b of inner wall 44.

As described, supply of hydrogen radical to the deposition space 34 is conducted uniformly, and uniformity of film quality of hydrogenated amorphous silicon carbide a-SiC:H formed on the substrate 100 can be provided.

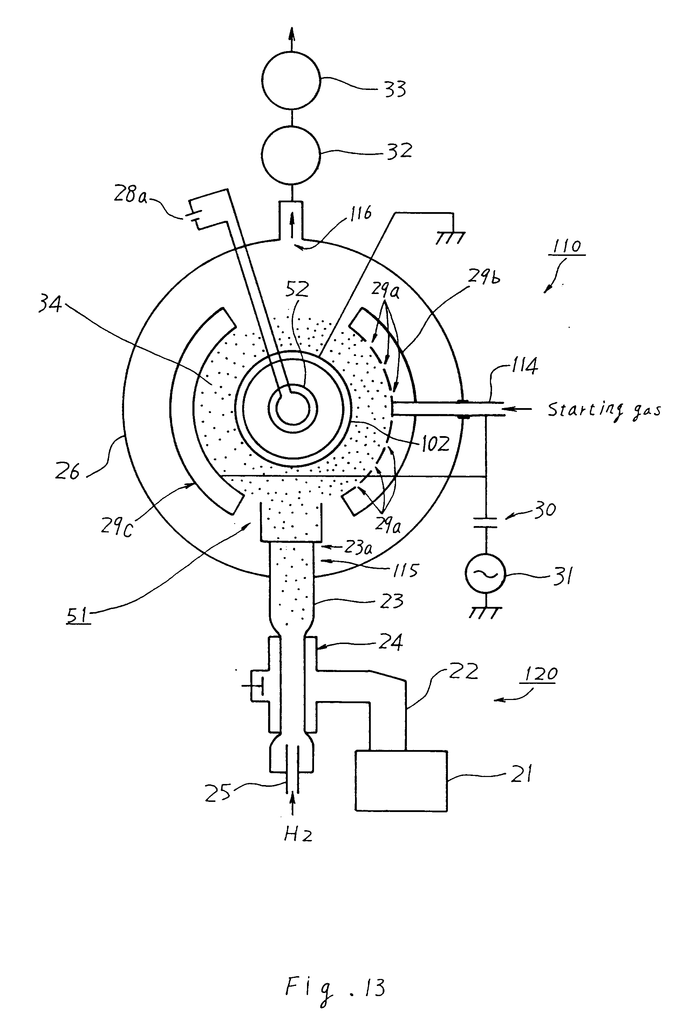

Fig. 13 is a diagram explanatory of apparatus used in accordance with another embodiment of the present invention. This embodiment represents a modification of the embodiment shown in Fig. 12, for application to a drum type substrate.

In this embodiment, the first electrode is provided by two divided electrodes 29b, 29c, each of which is connected with an RF source 31. Moreover, a heater 52 (c.f. 28 in Fig. 12) is formed cylindrically. A substrate 102 (100) is an aluminum tube of diameter 80 mm and length 260 mm for providing an a-Si photosensitive drum.

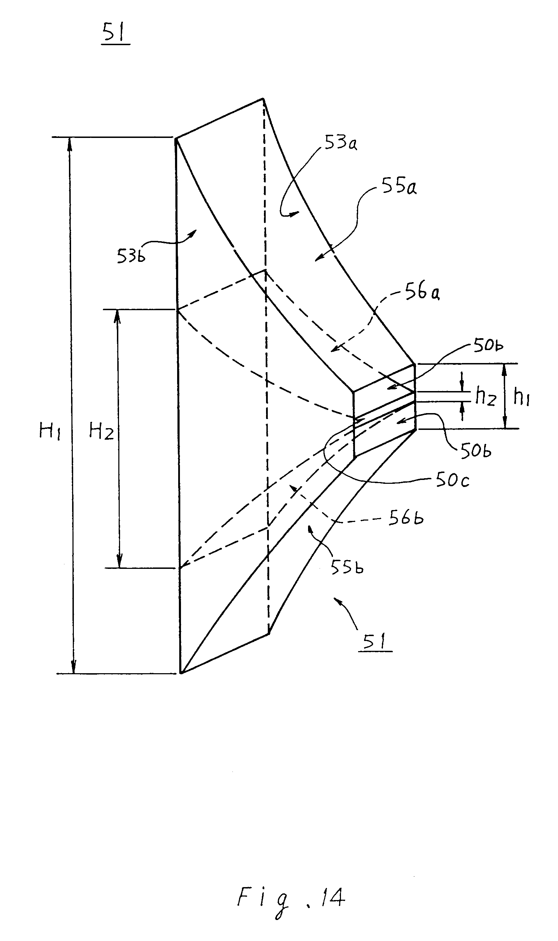

As shown in Fig. 14, a hydrogen radical introducing unit 51 is formed by coupling flared outer walls 55a, 55b and flared inner walls 56a, 56b, which, with side plates 53a, 53b, provide apertures of rectangular cross section increasing in size. The hydrogen radical introducing unit 51 is connected to end part 23a of quartz pipe 23, having a rectangular cross-section in this case, and is provided opposed to the deposition space 34 within the vacuum vessel 26. The hydrogen radical is supplied from openings 50a, 50b of the end part 51a of hydrogen radical introducing unit 51 to the deposition space 34 through paths (apertures) between the outer wall 55a and inner wall 56a, outer wall 55b and inner wall 56b, and through the path (aperture) between the inner walls 56a and 56b from the opening 50c.

For film formation, starting gas ($Si_2H_6$ 2 SCCM and $C_3H_8$ 10 SCCM) is introduced into the reactor vessel 26 through the first electrode 29b from the inlet port 114, and hydrogen ($H_2$) at 200 SCCM is introduced from the hydrogen gas introducing unit 25. An a-SiC:H film is formed with the temperature of the substrate 102 at 250°C, pressure in the reactor vessel 26 at 0.2 Torr (0.026 KPa), RF power at 100 W and microwave power at 540 W.

Table 8 shows differences between film characteristics at the centre and at an end portion of the cylindrical substrate 102, depending on the existence of the hydrogen radical introducing unit 51 (i.e. depending on whether or not unit 51 is provided).

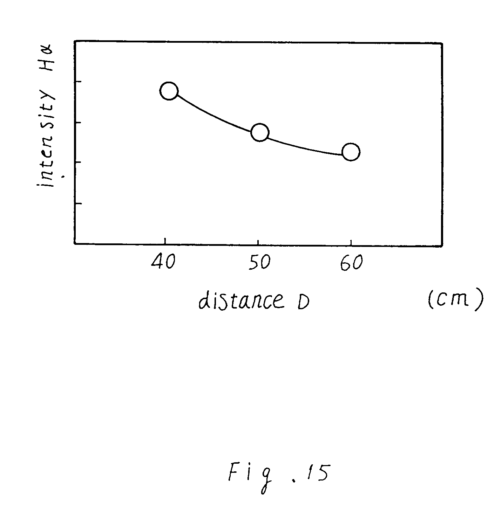

Incidentally, hydrogen radical 10 naturally has a lifetime, and when the substrate 100 (102) is distant from the hydrogen radical generating area, namely when the distance D between the deposition space 34 and hydrogen radical generating area is increased, the quantity of hydrogen radical reaching the deposition space 34 is reduced. That is, as shown in Fig. 15, when the distance D becomes longer, intensity of emitted light is reduced and concentration of hydrogen radical is also thereby reduced.

In the system of Fig. 13, a large-scale apparatus including the waveguide 22, plasma generating furnace 24

Table 8

| | | Hydrogen radical introducing unit 51 | |
|---|---|---|---|
| | | Existing | Not existing |
| Ununiformity of film forming rate | Center | $0.46\ \mu m/h$ | $0.46\ \mu m/h$ |
| | End part | $0.46$ | $0.44$ |
| Ununiformity of optical band gap $E_{gopt}$ | Center | $2.21\ eV$ | $2.21\ eV$ |
| | End part | $2.21$ | $2.12$ |
| Ununiformity of B value | Center | $674\ cm^{-1/2}\cdot eV^{-1/2}$ | $674\ cm^{-1/2}\cdot eV^{-1/2}$ |
| | End part | $670$ | $570$ |

and quartz pipe 23 is used for generating the hydrogen radical and accordingly there is a limit to the degree by which the relevant distance can be reduced.

The optical band gap $E_{gopt}$ and B value expressing density of constitution are very important for assessing film quality of a-SiC:H, and uniform or more uniform film quality can be obtained, and film forming rates become uniform or more uniform, when the hydrogen radical introducing unit 51 is provided.

14

In experiments, ratio $h_2/h_1$ (c.f Fig. 14) was varied from 0.1 to 0.5 and ratio $H_2/H_1$ (c.f. Fig. 14) was varied from 0.3 to 0.7. However, the results of Table 8 were obtained when $h_2/h_1$ = 0.2, $H_2/H_1$ = 0.5, at which values optimum results can be obtained.

The hydrogen radical introducing unit 51 shown in Fig. 14 can also be used to form a film on a flat substrate 100 in the same way as in the embodiment of the present invention illustrated in Fig. 11.

As an alternative to the system used in the above embodiments, a system in which microwaves are directly supplied to the reactor vessel, and both the starting gas and hydrogen gas are decomposed in the vicinity of the substrate, could be considered. However, this system involves a probability of reduced film quality because the starting gas is also decomposed by microwaves and the film deposited on the substrate is exposed to microwaves.

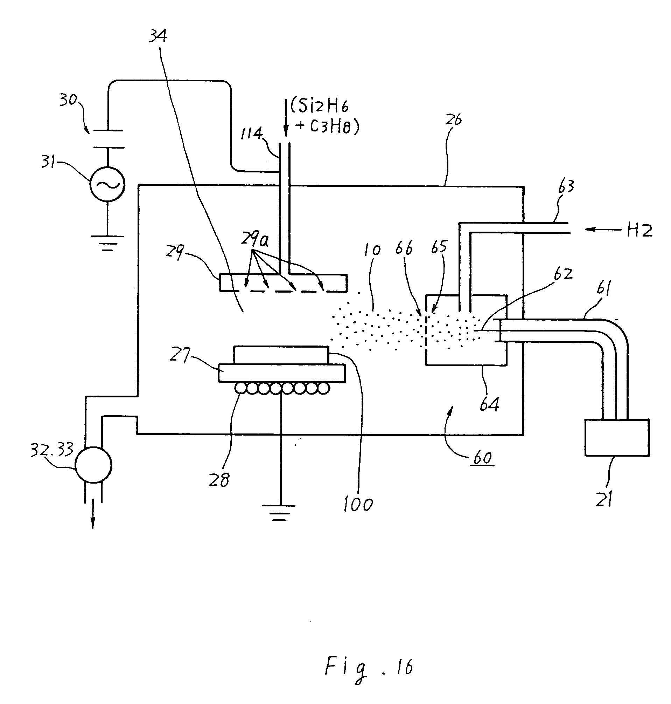

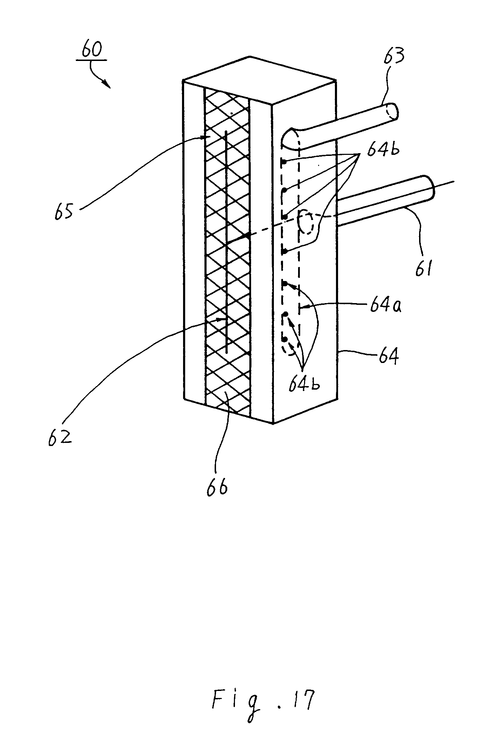

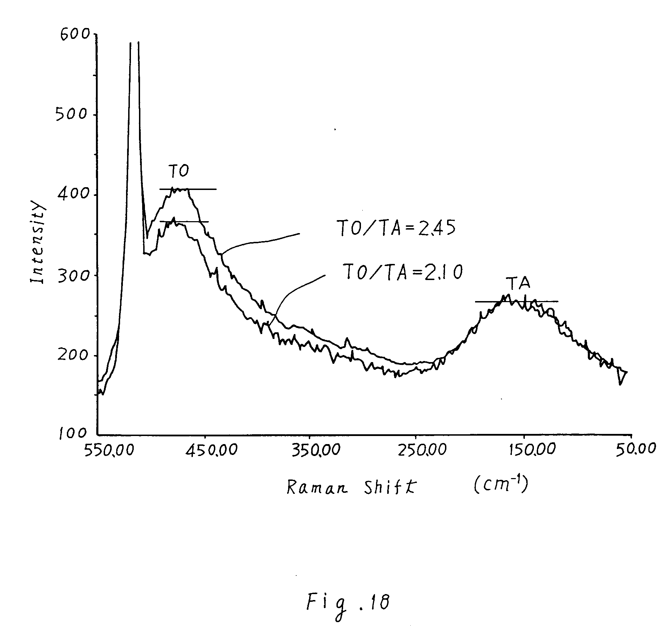

Fig. 16 shows thin film formation apparatus used in accordance with another embodiment of the present invention which is capable of effectively forming a high-quality film.

As shown in Fig. 16, the hydrogen radical ($\cdot$H) 10 is generated in the reactor vessel 26. That is, a hydrogen radical generator 60 comprises an antenna 62 connected to microwave oscillator 21 through a coaxial cable 61, a box-type vessel 64 to which hydrogen gas from source 4 (not shown) is introduced through a hydrogen gas introducing pipe 63, and a shielding member 66 which shields microwaves released into the box-type vessel 64 so that they cannot escape towards the substrate 100 from a hydrogen radical blowing port 65 of the box-type vessel 64.

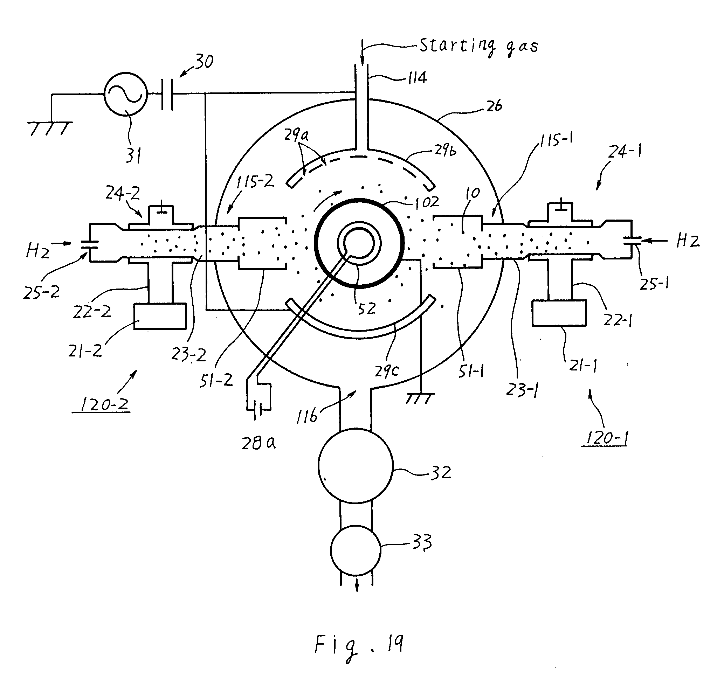

The hydrogen radical generator 60 comprises, as shown in detail in Fig. 17, a box-type vessel 64 having a blowing port 65, an antenna 62 and a shielding member 66. The vessel 64 has the dimensions of 30 cm (height), 3 cm (width) and 5 cm (depth). The gas introducing pipe 63 is connected to the upper part of the vessel 64 to supply hydrogen gas to a gas introducing path 64a formed along the longitudinal direction of the vessel 64. The hydrogen gas supplied is then introduced into the vessel 64 from opening holes 64b provided along the gas introducing path 64a. Moreover, the coaxial cable 62 is connected to the vessel 64 and the antenna 62 is formed by a stainless rod of diameter 1.0 mm covered with quartz, connected in the vessel 64 to coaxial cable 61 and extended in upper and lower directions. As cover for the antenna 62, quartz may be replaced with an insulator, fluoric resin, glass or SiC, etc., and covers which are resistant to heat and do not generate gas may be used.

The shielding member 66 is formed as a mesh of stainless wire of diameter 0.5 mm with an interval or mesh spacing of 5 mm and it is attached extending in the upper and lower direction at the blowing port 65. This hydrogen radical generator 60 is provided within the reactor vessel 26 at a position spaced by 100 mm from the substrate 100.

The substrate 100 is set on the second electrode 27 held by a substrate holder of dimensions 10 x 20 cm (not shown) and is grounded, and film formation on this substrate 100 is effected using the following procedures.

The microwaves generated by microwave oscillator 21 are sent to antenna 62 through coaxial cable 61, and $H_2$ gas sent from gas introducing pipe 63 is decomposed by the microwaves generated by the antenna 62 and becomes hydrogen radical 10. This hydrogen radical 10 is pulled on (attracted to) the substrate 100. Here, since the shielding member 66 is attached to the hydrogen radical blowing port 65 of the hydrogen radical generator 60, microwaves are shielded by the shielding member 66 and do not leak to the exterior of vessel 64. Meanwhile, the starting gas ($Si_2H_6$ + $C_3H_8$) is introduced from the starting gas introducing unit 114 and blows out into the deposition space 34. This gas is decomposed by RF discharge generated between electrodes 29 and 27 by the RF power from RF source 31 and is deposited as the a-SiC:H film on the substrate 100 heated by the heater 28. The internal pressure of the vacuum vessel 26 is adjusted by the exhausting systems 32 and 33. While the starting gas is decomposed and deposited by high-frequency discharge, the film surface is covered by the hydrogen radical 10 generated from the hydrogen radical generator 60 and thereby the constitution density of the a-SiC:H film can be improved. During film formation, the distance between the hydrogen radical generator 60 and the deposition space 34 (substrate 100) can be reduced to about 100 mm without decomposition of starting gas by microwaves and exposure of the substrate to microwaves, preventing leakage of microwaves from the hydrogen radical generator 60 as described above, and the radical can be sent effectively to the deposition space. Moreover, silicon system powder and film generated through decomposition of the starting gas by RF discharge do not easily adhere to the microwave antenna 62. The silicon powder does not easily adhere to the antenna 62 if $H_2$ gas is allowed to flow from the vicinity of antenna 62 with a flow rate 10 to 1000 times that of the starting gas, and this effect becomes more apparent by attaching the shielding member 66.

Next, more definite or concrete film forming conditions for the above apparatus, and characteristics of film formed under such conditions will then be explained.

The film forming conditions are that pressure is 0.2 Torr (0.026 KPa), substrate temperature is 250°C, RF power is 100 W, $Si_2H_6$ is 2 SCCM, $C_3H_8$ is 10 SCCM, $H_2$ is 200 SCCM and microwave power is 500 W.

Fig. 18 is an example of the results of Raman spectroscopy measurement of $a-Si_{1-x}C_x$:H film (x = 0.6) formed under such conditions. The TO/TA peak intensity ratio indicates small distortion of constitution of Si-Si coupling in the film and symmetry thereof and larger TO/TA ratio results in smaller distortion. From Fig. 18, the a-SiC:H film formed by the apparatus of this embodiment of the present invention appears to have a higher TO/TA ratio, is more dense and has improved film quality, as compared with a film formed by the prior art.

In relation to the above example, a flat-type substrate was used. It is also possible to form a film on a substrate attached on a cylindrical substrate holder. In such a case, the substrate is rotated during formation of a film. The a-Si photosensitive member using the a-SiC:H film formed by apparatus using such a cylindrical substrate as the surface protecting layer has a charging capability of 55V/$\mu$m, and does not exhibit any blurring effect in a case in which it is left for a night in an atmosphere at 35°C and 80% RH after continuous corona irradiation under the same conditions, and also shows good moisture proof characteristics.

In the above explanation, a shielding member is formed as a mesh, but it may be replaced with some other member suitable for shielding microwaves, for example, rods or lead wires spaced with a certain interval.

Fig. 19 is a diagram explanatory of another embodiment of the present invention and is different from the embodiment of Fig. 13 in that a plurality of hydrogen radical generating units are provided so that the hydrogen radical is sent to the substrate and deposition space from two or more directions through inlet ports 115-1, 115-2.

The first and second hydrogen radical generating units 120-1, 120-2 have the same constitution as the hydrogen radical generating unit 120 explained with reference to Fig. 13 and the hydrogen radical introducing units 51-1, 51-2 have the constitution shown in Fig. 14.

According to this embodiment, since the hydrogen radical is sent from two or more directions to the substrate or deposition space, the hydrogen radical can be applied uniformly or more uniformly and to this extent density of a-SiC:H film can be improved.

An example of film forming conditions for a surface protecting layer using the apparatus of the constitution of Fig. 19 are as follows:-

Pressure: 0.2 Torr (0.026 KPa)
Substrate temperature: 250°C
RF power: 100 W
Flow rate of $Si_2H_6$: 2 SCCM
Flow rate of $C_3H_8$: 10 SCCM
Flow rate of $H_2$: 200 SCCM
Microwave power: 500 W.

For providing the total of 200 SCCM flow rate of $H_2$, 100 SCCM is supplied from each of the hydrogen gas introducing pipes 25-1, 25-2 of the first and second hydrogen radical generating units 120-1, 120-2. In both cases, the hydrogen gas is decomposed in a plasma generating furnace 24-1, 24-2, becomes the hydrogen radical 10 which is thus supplied from two directions to the substrate 102.

The a-Si photosensitive member provided with a 0.2 $\mu$m surface protecting layer of a-SiC:H formed under the conditions described above, on a blocking layer of high B doped a-Si:H film of thickness 0.56 $\mu$m and a low B doped a-Si:H film of thickness 10 $\mu$m, did not generate blurring after continuous corona irradiation for two hours under atmospheric conditions of 35°C and 80% RH, even after being left for a night following such continuous corona irradiation.

The hydrogen radical introducing units 51-1, 51-2, each of the constitution shown in Fig. 14, are connected respectively at the end portions of quartz pipes 23-1, 23-2 and the hydrogen radical 10 generated in the plasma generating furnaces 24-1, 24-2 by microwaves supplied from microwave oscillators 21-1, 21-2 through waveguides 22-1, 22-2 is dispersed in the vertical direction of the substrate 102 and flows uniformly into the deposition space 34.

Results of comparison of TO/TA values in cases in which hydrogen radical introducing units 51-1 and 51-2 are provided, or such units are not provided, is indicated in Table 9.

Table 9

|  | Unit Not Provided | Unit Provided |
|---|---|---|
| Upper part | 2.0 | 2.3 |
| Centre | 2.4 | 2.4 |
| Lower part | 1.9 | 2.2 |

From Table 9, it is apparent that difference of TO/TA ratios at the upper part, centre and lower part of substrate can be reduced by adding the introducing units 51-1, 51-2.

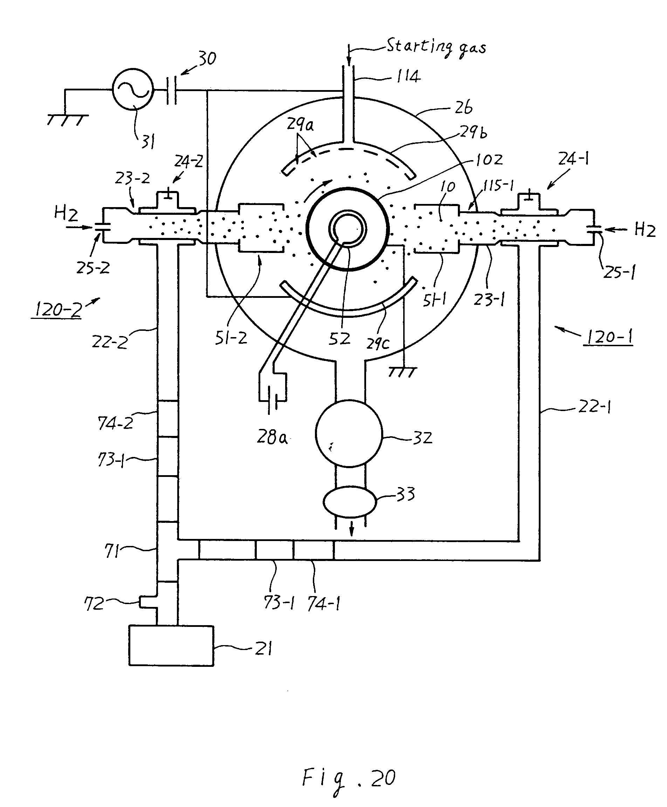

Fig. 20 is an explanatory diagram of a further embodiment of the present invention, differing from the embodiment shown in Fig. 19 in that one microwave oscillator is used in common for two hydrogen radical generating units 120-1, 120-2.

As shown in Fig. 20, the microwave output from the one microwave oscillator 21 passes an isolator 72 and is then divided by a microwave distributor 71 to waveguides 22-1, 22-2 of the hydrogen radical generating units 120-1, 120-2.

The waveguides 22-1, 22-2 are provided with power monitors 73-1, 73-2 and matching units 74-1, 74-2. Moreover, the microwave power of microwave oscillator 21 is 800 W.

With such a constitution, since the period of the microwave oscillator 21 is the same in respect of both hydrogen radical generating units 120-1, 120-2, reflection caused by deviation of period increases and hereby plasma can be maintained in a stable condition.

Accordingly, this embodiment realises stable formation of film for a long period of time.

In the constitution shown in Fig. 20, surface protecting layer formation conditions can be set such that pressure is 0.2 Torr (0.026 KPa), substrate temperature is 25°C, RF power is 100 W, $Si_2H_6$ is 2 SCCM, $C_3H_8$ is 10 SCCM, $H_2$ is 200 SCCM and microwave power is 800 W, and 100 SCCM of $H_2$ is supplied in each respective one of two directions, to give the total of 200 SCCM of $H_2$ as in the case of the embodiment of Fig. 5.

As a result, reflection has been reduced to 1/2 to 1/3 in comparison with a case of using the microwave oscillator and unstable operation of plasma generated periodically can be eliminated. Thereby, continuous film formation for a long period of time can now be realised.

The blocking layer is formed on a cylindrical Al substrate as a higher B doped a-Si:H film with a thickness of 0.56 $\mu$m, while the photosensitive layer is formed as a lower B doped a-Si:H film with a thickness of 10 $\mu$m and the surface protecting layer is deposited to a thickness of 0.15 $\mu$m under the film formation conditions described above. The a-Si:H film having a surface protecting layer so formed did not generate blurring after the continuous corona irradiation for two hours under atmosphere conditions of 35° and 80% RH and still after the leaving during a night from such continuous irradiation.

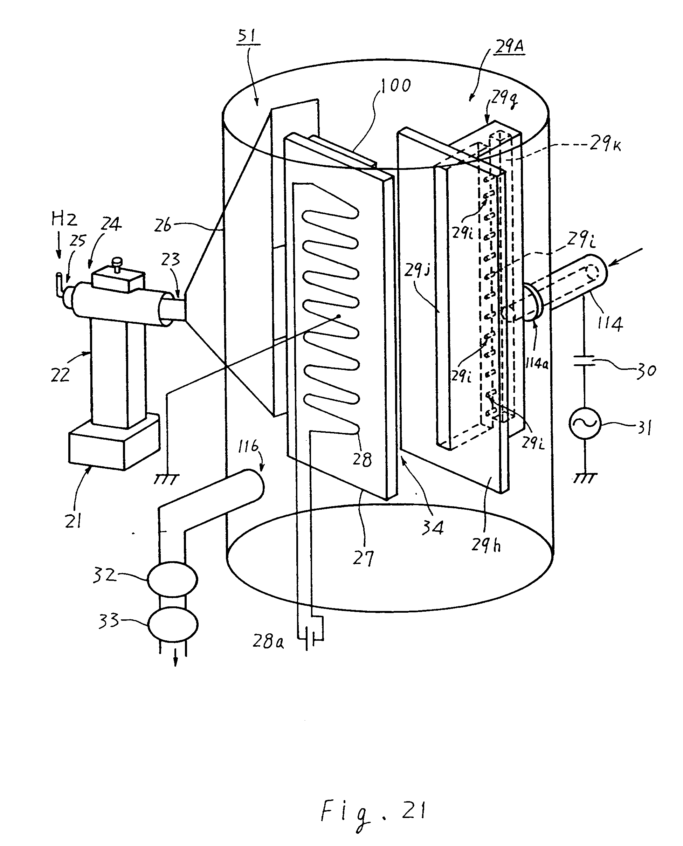

Fig. 21 shows a modification of the thin film formation apparatus 110 as shown in Fig. 11. In Fig. 21, features similar to those of Fig. 11 are indicated by the same reference numerals. The modified apparatus is the same as in Fig. 11 except that the first electrode 29 is replaced with a hollow cathode electrode 29A and a hydrogen radical introducing unit 51 of a constitution as shown in Fig. 14 is also added.

In this embodiment, the hollow cathode electrode 29A includes a rectangular flat portion 29h and an upright portion 29g integrally projected from the flat portion 29h along the longitudinal axis thereof. The upright portion 29g has a rectangular hollow space 29j formed therein, which is extended in the flat portion 29h and opened at a discharge surface thereof.

As seen from Figures, the upright portion 29g has a plurality of opening holes 29i formed at the head thereof aligned with each other. The electrode 29A is suspended from a side wall of the reactor vessel 26.

In particular, the head of the upright portion 29g is projected through the side wall of the reactor vessel 26 and is attached to the side wall of the reactor vessel 26 through the intermediary of an insulator (not shown), and a header element 114a, by which the inlet port 114 is defined, is mounted on the head top of the upright portion 29g in such a manner that the inlet port 114 is in communication with the hollow space 29j through the opening holes 29i.

In operation, air is first drawn from the reactor vessel 26 through the outlet port 116 by the vacuum pump 32, 33 until a pressure in the reactor vessel 26 is lower than $10^{-3}$ Torr ($1.3 \times 10^{-4}$ KPa). Then the substrate 100 is heated to a predetermined temperature by the electric heater 28 while a starting gas is successively introduced into the reactor vessel 26 through the inlet port 114, the opening holes 29i, and the hollow space 29j, so that the pressure therein is maintained at a predetermined level of from about 0.01 and about 0.3 Torr (0.0013 KPa, 0.39 KPa). The vacuum pump 32, 33 is continuously driven.

When a predetermined RF voltage is applied between the first and second electrodes 29A and 27 by the RF electric source 31 to cause an RF discharge therebetween, the electrons generated by the RF discharge collide with the starting gas molecules so that a plasma zone is formed between the first and second electrodes 29A and 27. At the beginning of the RF discharge, the electrons, which are vibrated in the vicinity of the first electrode 29A, are captured by the first electrode 29A due to the existence of the blocking capacitor 30, so that a potential of the first electrode 29A is self-biased toward the negative side. If the flat portion (e.g. confronting 29h) of the second electrode 27 is wider than the flat portion 29h of the first electrode 29A, i.e. if the opposed area of the flat portion of electrode 27 is smaller than that of the flat portion 29h, the capture of the electrons by the first electrode 29A is facilitated.

When the first electrode 29A is saturated with captured electrons, the first and second electrodes 29A and 27 behave as a cathode and an anode, respectively, as if a direct current voltage were applied therebetween, so that the electrons existing in the hollow space 29j are rapidly vibrated by the electrical repulsion which the electrons receive from the hollow space wall.

Namely, the probability of collision between the electrons and the starting gas molecules in the hollow space 29j is considerably enhanced, so that a high-density plasma is generated in a central portion of the discharge zone, which is in the vicinity of the hollow space 29j.

As a result, the starting gas is directly introduced into the high-density plasma and the active spaces are more efficiently dissociated from the starting gas in comparison with a conventional RF discharge plasma-assisted CVD process. Moreover, the hydrogen radical ($\cdot$H), generated when the microwave oscillator 21 is driven simultaneously with application of the RF power, is supplied to the plasma zone 34 formed between the first and second electrodes 29A, 27 through the hydrogen radical introducing unit 51.

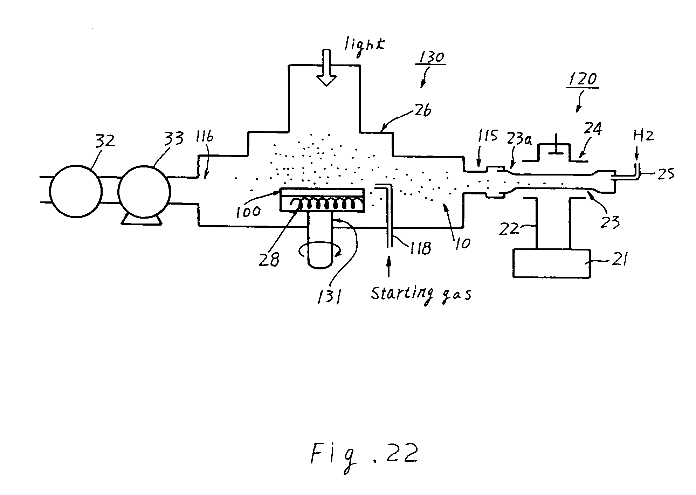

Fig. 22 is an explanatory diagram of a further embodiment of the present invention. In this embodiment, a hydrogen radical generating unit 120 is applied to an optical CVD apparatus 130.

The optical CVD apparatus 130 is formed by a reactor vessel 26, an introducing pipe 118 for supplying starting gas to the reactor vessel 26, a vacuum pump including a mechanical booster pump 32 connected to the outlet port 116 and a rotary pump 33 in order to evacuate the reactor vessel 26, a heater 28 for heating substrate 100, a substrate holder 131 which may be rotated together with the heater 28 while it is holding the substrate 100, and a light source (not shown) which irradiates the substrate holder 131 with light from the exterior of reactor vessel 26 and decomposes the starting gas, introduced from the introducing pipe 118, to obtain a plasma condition.

The end portion 23a of the quartz pipe 23 of the hydrogen radical generating unit 120 is connected to the optical CVD apparatus 130 through the inlet port 115 as in the case of the embodiment shown in Fig. 4.

Therefore, this optical CVD apparatus 130 can supply a large amount of hydrogen radical in the vicinity of the substrate holder 131.

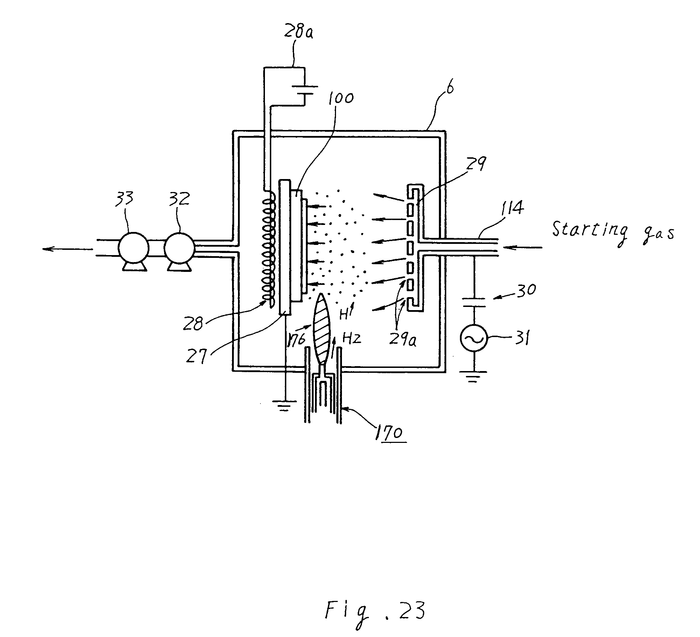

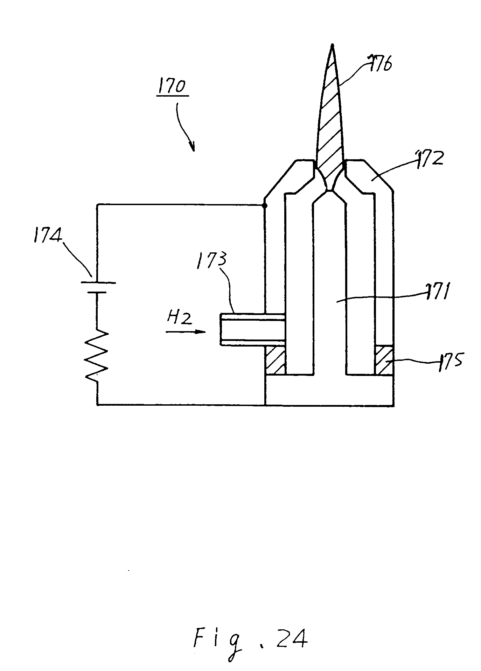

Fig. 23 is an diagram explanatory of another embodiment of the present invention. In this Figure, 170 designates a hydrogen radical generating apparatus, a detailed example of which is shown in Fig. 24.

The hydrogen radical generating apparatus 170 uses an arc discharge system, providing a cathode 171, an anode 172 and a $H_2$ gas supply port 173, and both cathode 171 and anode 172 are connected with a power source 174. 175 designates an insulator. Namely, this embodiment of the present invention uses an arc discharge system hydrogen radical generating apparatus 170 as the hydrogen radical generating apparatus. This apparatus 170 reduces the discharge sustaining voltage to about 1/10 immediately after it increases rapidly when a current higher than the glow discharge is supplied from the power source 174. The cathode 171 is heated until it turns to red, emitting hot electrons. Thereby, the plasma is in a thermal equilibrium condition, wherein electron temperature becomes almost equal to gas temperature and thereby the $H_2$ gas is dissociated in an almost 100% plasma condition. The gas having a higher hydrogen radical ratio than that of the gas obtained using microwaves can be obtained by extending an arc rod 176 thus generated up to the area in the vicinity of the substrate 100.

In respective embodiments described above, disilane $Si_2H_6$, propane $C_3H_8$, diborane $B_2H_6$ are used as starting gas but gases expressed by the general expressions $Si_nH_{3n}$, $C_nH_{2n+2}$, $B_nH_{3n}$ may be used in combination.

Embodiments of the present invention are concerned in particular with hydrogenated amorphous silicon carbide used for instance as the surface protecting layer of a photosensitive member for electrophotographic apparatus, or as an insulating layer in a thin film transistor or solar cell. With a view to prevention of generation of image blurring on the photosensitive member under conditions of high-humidity atmosphere, the content (x) of carbon in hydrogenated amorphous silicon carbide expressed by the general formula a-$Si_{1-x}C_x$:H is in the range of $0.4 \leq x \leq 0.8$ and a ratio (TO/TA) of the peak (TO) amplitude appearing in the vicinity of 480 cm$^{-1}$ and the peak (TA) amplitude appearing in the vicinity of 150 cm$^{-1}$, observed by laser Raman spectroscopy measurement using an excitation laser of $Ar^+$ 488 nm, is set to 2.0 or higher. Such carbide also has high insulation properties, suitable for providing insulating layers.

Embodiments of the present invention provide methods and modes of use of apparatuses for thin formation. Such methods and modes of use of apparatus can be employed not only for preparing thin films on a substrate for use in a photosensitive member, but also for other purposes, for example for forming insulating thin films for thin film transistors or solar cells.

**Claims**

1. Use of thin film formation apparatus for forming a dense, thin protective film of hydrogenated amorphous material on a substrate, said material containing an ingredient to reduce surface wettability, said apparatus comprising a reactor vessel, a first introducing means, a plasma generating means, a second introducing means, and a hydrogen radical generating means,

in which use

the substrate is placed in the reactor vessel, the first introducing means introduce starting gas into said reactor vessel, the plasma generating means generate plasma in said reactor vessel, the second introducing means deliver hydrogen gas, and the hydrogen radical generating means generate hydrogen radicals by decomposing hydrogen gas supplied by said second introducing means, and the generated hydrogen radicals are sent to said substrate in the reactor vessel.

2. Use as claimed in claim 1, said apparatus further comprising a hydrogen radical introducing unit which uniformly sends said hydrogen radicals to said substrate.

3. Use as claimed in claim 1 or 2, said first introducing means including a gas source containing disilane and a gas source containing propane.

4. Use as claimed in claim 1, 2 or 3, said second introducing means including a gas source containing hydrogen gas.

5. Use as claimed in claim 1, 2, 3 or 4, said plasma generating means including a first electrode receiving a supply of radio frequency power, and a grounded second electrode.

6. Use as claimed in any preceding claim, said hydrogen radical generating means including a microwave oscillator, a waveguide guiding microwaves, a quartz pipe to which said hydrogen gas is applied, and a plasma generating furnace applying microwaves guided through the waveguide to said quartz pipe.

7. Use as claimed in any preceding claim, said hydrogen radical generating means including a microwave oscillator, a hydrogen radical generating vessel provided within said reactor vessel and having a hydrogen radical blowing port, a hydrogen gas introduction path by which hydrogen gas is supplied to said vessel, an antenna in said vessel and receiving microwaves, a member guiding microwaves from said microwave oscillator to said antenna, and a member in said blowing port allowing flow of hydrogen radicals and shielding microwaves.

8. Use as claimed in claim 7, the microwave shielding member being formed as a wire mesh.

9. Use as claim in any preceding claim, in which a plurality of such hydrogen radical generating means are provided.

10. Use as claimed in any preceding claim, in which the or each of said hydrogen radical generating means generates the hydrogen radicals in said reactor vessel.

11. Use as claimed in any one of claims 1 to 6, said hydrogen radical generating means including a microwave oscillator, a plurality of quartz pipes to which said hydrogen gas is respectively supplied, and a waveguide guiding the microwaves from said microwave oscillator to each quartz pipe.

12. Use as claimed in any preceding claim, the apparatus further comprising a gas source containing diborane.

**13.** A method of forming a dense, thin protective film of hydrogenated amorphous material on a substrate, said material containing an ingredient to reduce surface wettability, said method comprising steps of:-
(a) forming said film by generating a plasma of a starting gas suitable for forming said material within a deposition space where a substrate is positioned,
(b) generating hydrogen radicals by decomposing a hydrogen gas, and
(c) introducing a sufficient amount of hydrogen radicals into said deposition space in the proximity of the substrate to cover the surface of the amorphous material film as it forms.

**14.** A method as claimed in claim 13, wherein said hydrogen radicals are generated by collision of microwaves and hydrogen.

**15.** A method as claimed in claim 13 or 14, wherein said hydrogen radicals are introduced into said deposition space from a plurality of directions.

**16.** A method of forming a hydrogenated amorphous silicon photosensitive member comprising the steps for:-
(a) placing a conductive substrate, to be used for electrophotography, within a reactor vessel,
(b) reducing the pressure within the reactor vessel,
(c) introducing a first starting gas including $Si_nH_{3n}$ ($n \geq 2$) gas and $B_nH_{3n}$ gas into the reduced pressure reactor vessel and generating a plasma from the first starting gas to form a B (boron) doped a-Si:H photosensitive member on the substrate, and
(d) introducing a second starting gas including $Si_nH_{3n}$ gas and $C_nH_{2n+2}$ gas into the reduced pressure reactor vessel and generating plasma from the second starting gas to form a surface protecting layer of a-SiC:H on said a-Si:H photosensitive member,
(e) simultaneously with the introduction of the second starting gas into said vessel, introducing a sufficient amount of hydrogen radicals into the reactor vessel in the proximity of the photosensitive member to cover the surface of the protective layer as it forms.

**17.** A hydrogenated amorphous silicon carbide expressed by the general formula $a-Si_{1-x}C_x:H$ and having a constitution such that a ratio (TO/TA) of the peak (TO) amplitude appearing in the vicinity of 480 cm$^{-1}$ and the peak (TA) amplitude appearing in the vicinity of 150 cm$^{-1}$ observed by laser Raman spectroscopy measurement using an excitation laser of Ar$^+$ 488 nm is 2.0 or higher, and such that the content of carbon (x) is in the range of $0.4 \leq x \leq 0.8$.

**18.** Use of the carbide of claim 17 in a surface protecting layer on a photosensitive member.

**19.** Use of the carbide of claim 17 in an insulating film.

**Patentansprüche**

**1.** Verwendung einer Dünnfilmbildungsvorrichtung zum Bildung eines dichten, dünnen Schutzfilms aus hydrogeniertem amorphen Material auf einem Substrat, wobei das Material einen Bestandteil zur Herabsetzung der Oberflächenbenetzbarkeit enthält, wobei die Vorrichtung einen Reaktorbehälter, eine erste Einführeinrichtung, eine Plasmaerzeugungseinrichtung, eine zweite Einführeinrichtung und eine Wasserstoffradikalerzeugungseinrichtung umfaßt,
bei welchem Gebrauch das Substrat im Reaktorbehälter angeordnet ist, die ersten Einführungseinrichtungen Startgas in den Reaktorbehälter einführen, die Plasmaerzeugungseinrichtungen Plasma im Reaktorbehälter erzeugen, die zweiten Einführeinrichtungen Wasserstoffgas ausgeben, und die Wasserstoffradikalerzeugungseinrichtungen Wasserstoffradikale dadurch erzeugen, daß sie durch die zweiten Einführungseinrichtungen zugeführtes Wasserstoffgas aufspalten und die erzeugten Wasserstoffradikale zum Substrat im Reaktorbehälter überführt werden.

**2.** Verwendung nach Anspruch 1, bei der die Vorrichtung weiter eine Wasserstoffradikaleinführeinheit umfaßt, die die Wasserstoffradikale gleichmäßig zum Substrat übermittelt.

**3.** Verwendung nach Anspruch 1 oder 2, bei der die erste Einführeinrichtung eine Disilan enthaltende Gasquelle und eine Propan enthaltende Gasquelle umfaßt.

**4.** Verwendung nach Anspruch 1, 2 oder 3, bei der die zweite Einführeinrichtung eine Wasserstoffgas enthaltende Gasquelle umfaßt.

**5.** Verwendung nach Anspruch 1, 2, 3 oder 4, bei der die Plasmaerzeugungseinrichtung eine erste Elektrode, die eine Zuführung von Hochfrequenzleistung empfängt, und eine geerdete zweite Elektrode umfaßt.

**6.** Verwendung nach einem beliebigen vorhergehenden Anspruch, bei der die Wasserstoffradikalerzeugungseinrichtung einen Mikrowellenoszillator, einen mikrowellenführenden Wellenleiter, ein Quarzrohr, zu dem Wasserstoffgas gegeben wird, und einem Plasmaerzeugungsofen umfaßt, der durch den Wellenleiter zum Quarzrohr geführte Mikrowellen anwendet.

**7.** Verwendung nach einem beliebigen vorhergehenden Anspruch, bei der die Wasserstoffradikalerzeugungseinrichtung einen Mikrowellenoszillator, einen Wasserstoffradikalenerzeugungsbehälter, der im Reaktorbehälter vorgesehen ist und eine Wasserstoffradikalblasöffnung aufweist, einen Wasserstoffgaseinführweg, durch den Wasserstoffgas zum Behälter zugeführt wird, eine Antenne in dem Behälter und die Mikrowellen empfängt, ein Mikrowellen von dem Mikrowellenoszillator zur Antenne führendes Element und ein Element in der Blasöffnung umfaßt, die das Strömen von Wasserstoffradikalen und die Abschirmung von Mikrowellen gestattet.

**8.** Verwendung nach Anspruch 7, bei der das Mikrowellenabschirmelement als Drahtgitter gebildet ist.

**9.** Verwendung nach einem beliebigen vorhergehenden Anspruch, bei dem eine Anzahl derartiger Wasserstoffradikalerzeugungseinrichtungen vorgesehen ist.

**10.** Verwendung nach einem beliebigen vorhergehenden Anspruch, bei der die oder jede der Wasserstoffradikalerzeugungseinrichtung(en) die Wasserstoffradikale in dem Reaktorbehälter erzeugt.

**11.** Verwendung nach einem beliebigen der Ansprüche 1 bis 6, bei der die Wasserstoffradikalerzeugungseinrichtung einen Mikrowellenoszillator, eine Anzahl von Quarzrohren, zu denen das Wasserstoffgas jeweils zugeführt wird, und einen die Mikrowellen von dem Mikrowellenoszillator zu jedem Quarzrohr führenden Wellenleiter umfassen.

**12.** Verwendung nach einem beliebigen vorhergehenden Anspruch, bei der die Vorrichtung weiter eine Diboran enthaltende Gasquelle umfaßt.

**13.** Verfahren zur Bildung eines dichten, dünnen Schutzfilms aus hydrogeniertem amorphen Material auf einem Substrat, wobei das Material einen Bestandteil zur Herabsetzung der Oberflächenbenetzbarkeit enthält, wobei das Verfahren die Schritte umfaßt, daß:

(a) der Film dadurch gebildet wird, daß ein Plasma eines zur Bildung des Materials geeigneten Startgases in einem Abscheidungsraum erzeugt wird, wo ein Substrat angeordnet ist,

(b) Wasserstoffradikale dadurch erzeugt werden, daß ein Wasserstoffgas aufgespalten wird, und

(c) eine ausreichende Menge von Wasserstoffradikalen in den Abscheidungsraum in der Nähe des Substrats eingeführt wird, um die Oberfläche des amorphen Materialfilms bei dessen Bildung zu überziehen.

**14.** Verfahren nach Anspruch 13, bei dem die Wasserstoffradikale durch Kollision von Mikrowellen und Wasserstoff erzeugt werden.

**15.** Verfahren nach Anspruch 13 oder 14, bei dem die Wasserstoffradikale in den Abscheidungsraum in einer Vielzahl von Richtungen eingeführt werden.

**16.** Verfahren zur Bildung eines lichtempfindlichen Elementes mit hydrogeniertem amorphen Silicium, umfassend die Schritte, daß:

(a) ein leitfähiges Substrat zur Verwendung für die Elektrophotographie in einem Reaktorbehälter angeordnet wird,

(b) der Druck im Reaktorbehälter herabgesetzt wird,

21

(c) ein erstes Startgas, das $Si_nH_{3n}$ (n ≥ 2) Gas und $B_nH_{3n}$-Gas in den Reaktorbehälter mit herabgesetztem Druck eingeführt wird und ausgehend von dem ersten Startgas ein Plasma zur Bildung eines mit B (Bor) dotierten lichtempfindlichen a-Si:H-Elementes auf dem Substrat eingeführt wird und

(d) ein zweites Startgas, das $Si_nH_{3n}$-Gas und $C_nH_{2n+2}$-Gas enthält, in den Reaktorbehälter mit verringertem Druck eingeführt wird und Plasma ausgehend vom zweiten Startgas zur Bildung einer Oberflächenschutzschicht aus a-SiC:H auf dem lichtempfindlichen a-Si:H-Elementen erzeugt wird,

(e) gleichzeitig mit der Einführung des zweiten Startgases in dem Behälter eine ausreichende Menge an Wasserstoffradikalen in den Reaktorbehälter in der Nähe des lichtempfindlichen Elementes eingeführt wird, um die Oberfläche der Schutzschicht bei deren Bildung zu überdecken.

17. Hydrogeniertes amorphes Siliciumcarbid, ausgedrückt durch die allgemeine Formel $a-Si_{1-x}C_x:H$ und aufweisend einen Aufbau derart, daß ein Verhältnis (TO/TA) der Peak (TO)-Amplitude, die in der Nähe von 480 $cm^{-1}$ auftritt, und der Peak (TA)-Amplitude, die in der Nähe von 150 $cm^{-1}$ auftritt, beobachtet durch Raman-Laserspektroskopiemessung unter Verwendung eines Anregungslasers von $Ar^+$ 488 nm 2,0 oder höher ist, und derart, daß der Kohlenstoffgehalt (x) im Bereich von 0,4 ≤ x ≤ 0,8 liegt.

18. Verwendung des Carbids von Anspruch 17 bei einer Oberflächenschutzschicht eines lichtempfindlichen Elementes.

19. Verwendung des Carbids von Anspruch 17 bei einem Isolierfilm.

**Revendications**

1. Application d'un appareil de formation de films minces à la formation d'un film protecteur mince et dense d'un matériau amorphe hydrogéné sur un substrat, le matériau contenant un ingrédient destiné à réduire la mouillabilité de la surface, l'appareil comprenant un réacteur, un premier dispositif d'introduction, un dispositif générateur d'un plasma, un second dispositif d'introduction et un dispositif générateur de radicaux hydrogène,

dans laquelle

le substrat est placé dans le réacteur, le premier dispositif d'introduction introduit un gaz initial dans le réacteur, le dispositif générateur de plasma crée un plasma dans le réacteur, le second dispositif d'introduction transmet de l'hydrogène gazeux, et le dispositif générateur de radicaux hydrogène crée des radicaux hydrogène par décomposition d'hydrogène gazeux transmis par le second dispositif d'introduction, et les radicaux hydrogène créés sont transmis vers le substrat placé dans le réacteur.

2. Application selon la revendication 1, l'appareil comprenant en outre une unité d'introduction de radicaux hydrogène qui transmet uniformément les radicaux hydrogène au substrat.

3. Application selon la revendication 1 ou 2, dans laquelle le premier dispositif d'introduction comprend une source de gaz contenant du disilane et une source de gaz contenant du propane.

4. Application selon la revendication 1, 2 ou 3, dans laquelle le second dispositif d'introduction comprend une source de gaz contenant de l'hydrogène gazeux.

5. Application selon la revendication 1, 2, 3 ou 4, dans laquelle le dispositif générateur de plasma comprend une première électrode qui reçoit de l'énergie à hautes fréquences, et une seconde électrode qui est à la masse.

6. Application selon l'une quelconque des revendications précédentes, dans laquelle le dispositif générateur de radicaux hydrogène comprend un oscillateur en hyperfréquences, un guide d'onde qui guide des hyperfréquences, un tube de quartz auquel est transmis l'hydrogène gazeux, et un four générateur de plasma destiné à appliquer les hyperfréquences guidées dans le guide d'onde au tube de quartz.

7. Application selon l'une quelconque des revendications précédentes, dans laquelle le dispositif générateur de radicaux hydrogène comprend un oscillateur en hyperfréquences, un récipient générateur de radicaux hydrogène placé dans le réacteur et ayant un orifice de soufflage de radicaux hydrogène, un trajet d'introduction d'hydrogène gazeux par lequel l'hydrogène gazeux est transmis au récipient, une antenne placée dans le récipient et recevant les hyperfréquences, un organe guidant les hyperfréquences de l'oscillateur en hyperfréquences à l'antenne, et un organe placé dans l'orifice de soufflage et permettant la circulation des radicaux hydrogène et assurant la protection contre les hyperfréquences.

8. Application selon la revendication 7, dans laquelle l'organe de blindage contre les hyperfréquences est formé d'une grille de fil.

9. Application selon l'une quelconque des revendications précédentes, dans laquelle plusieurs dispositifs générateurs de radicaux hydrogène sont incorporés.

10. Application selon l'une quelconque des revendications précédentes, dans laquelle le dispositif générateur ou chaque dispositif générateur de radicaux hydrogène crée des radicaux hydrogène dans le réacteur.

11. Application selon l'une quelconque des revendications 1 à 6, dans laquelle le dispositif générateur de radicaux hydrogène comprend un oscillateur en hyperfréquences, plusieurs tubes de quartz auquel l'hydrogène gazeux est transmis, et un guide d'onde qui guide les hyperfréquences de l'oscillateur en hyperfréquences à chaque tube de quartz.

12. Application selon l'une quelconque des revendications précédentes, dans laquelle l'appareil comprend en outre une source de gaz contenant du diborane.

13. Procédé de formation d'un film protecteur mince et dense d'un matériau amorphe hydrogéné sur un substrat, le matériau contenant un ingrédient destiné à réduire la mouillabilité de la surface, le procédé comprenant les étapes suivantes :
    (a) la formation du film par création d'un plasma d'un gaz initial convenant à la formation du matériau dans un espace de dépôt dans lequel est placé un substrat,
    (b) la création de radicaux hydrogène par décomposition d'hydrogène gazeux, et
    (c) l'introduction d'une quantité suffisante de radicaux hydrogène dans l'espace de dépôt à proximité du substrat afin que la surface soit recouverte d'un film du matériau amorphe dès sa formation.

14. Procédé selon la revendication 13, dans lequel les radicaux hydrogène sont créés par collision d'hyperfréquences et d'hydrogène.

15. Procédé selon la revendication 13 ou 14, dans lequel les radicaux hydrogène sont introduits dans l'espace de dépôt dans plusieurs directions.

16. Procédé de formation d'un organe photosensible de silicium amorphe hydrogéné, comprenant les étapes suivantes :
    (a) la disposition d'un substrat conducteur, destiné à être utilisé pour l'électrophotographie, à l'intérieur d'un réacteur,
    (b) la réduction de la pression dans le réacteur,
    (c) l'introduction d'un premier gaz initial contenant $Si_nH_{3}n$ ($n \geq 2$) gazeux et $B_nH_{3n}$ gazeux dans le réacteur à pression réduite, et la création d'un plasma à partir du premier gaz initial pour la formation d'un organe photosensible de a-Si:H dopé par B (bore) sur le substrat, et
    (d) l'introduction d'un second gaz initial contenant $Si_nH_{3n}$ gazeux et $C_nH_{2n+2}$ gazeux dans le réacteur à pression réduite, et la création d'un plasma à partir du second gaz initial pour la formation d'une couche protectrice de surface de a-SiC:H sur l'organe photosensible de a-Si:H,
    (e) simultanément à l'introduction du second gaz initial dans le réacteur, l'introduction d'une quantité suffisante de radicaux hydrogène dans le réacteur à proximité de l'organe photosensible afin que la surface de la couche protectrice soit recouverte dès sa formation.

17. Carbure de silicium amorphe hydrogéné représenté par la formule générale a-$Si_{1-x}C_x$:H, ayant une construction telle que le rapport TO/TA de l'amplitude de crête (TO) apparaissant au voisinage de 480 cm$^{-1}$ et de l'amplitude de crête (TA) apparaissant au voisinage de 150 cm$^{-1}$, observées par une mesure par spectroscopie Raman avec un laser d'excitation de Ar$^+$ à 488 nm, est supérieur ou égal à 2,0, et tel que la teneur en carbone (x) est comprise dans la plage $0,4 \leq x \leq 0,8$.

18. Application du carbure selon la revendication 17 à une couche protectrice de surface formée sur un organe photosensible.

19. Application du carbure selon la revendication 17 à un film isolant.

| | |
|---|---|
| a-SiC:H | —105 |
| low B doped a-Si:H | —104 |
| high B doped a-Si:H | —103 |
| Aℓ | —100 |

Fig. 1

Fig. 2

Fig. 3

Fig. 4

Fig. 5

Fig. 6

Fig. 7

Fig. 8

Fig. 9

33

Fig. 10

Fig.11

Fig.12

Fig . 13

51

Fig. 14

Fig . 15

Fig. 16

Fig . 17

Fig .18

Starting gas

Fig . 19

Fig. 20

Fig. 21

Fig. 22

Fig . 23

Fig. 24